# EUROPEAN PATENT APPLICATION

(11) **EP 4 693 401 A1**
(43) Date of publication of application: **11.02.2026**
(21) Application number: 24778826.8
(22) Date of filing: 19.02.2024
(51) Int. Cl.: H01L 25/04, H01L 23/36, H01L 27/146

(54) **SUBSTRATE DEVICE, ELECTRONIC DEVICE, ELECTRONIC APPARATUS, METHOD FOR MANUFACTURING ELECTRONIC DEVICE, AND METHOD FOR MANUFACTURING ELECTRONIC APPARATUS**

(30) Priority: 30.03.2023 JP 2023055472
(71) Applicant: Sony Semiconductor Solutions Corporation, Atsugi-shi, Kanagawa 243-0014 (JP)
(72) Inventor: YASUKAWA Hirohisa, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/005645
(87) International publication number: WO 2024/202681

(57) **Abstract**

To provide a board apparatus including a wiring layer electrically connecting a plurality of dies to each other and capable of improving productivity while suppressing deterioration of electrical characteristics.

The board apparatus according to the present technology includes a wiring board and a wiring layer protruding from one surface of the wiring board and electrically connecting a plurality of dies to each other. With the board apparatus according to the present technology, it is possible to provide a board apparatus including a wiring layer electrically connecting a plurality of dies to each other and capable of improving productivity while suppressing deterioration of electrical characteristics.

## Description

### TECHNICAL FIELD

The technology according to the present disclosure (hereinafter also referred to as the "present technology") relates to a board apparatus, an electronic apparatus, an electronic device, a method for manufacturing the electronic apparatus, and a method for manufacturing the electronic device.

### BACKGROUND ART

Board apparatuses that electrically connect a plurality of dies to each other via a bridge structure (wiring layer) disposed in a cavity of a wiring board are conventionally known (see, for example, Patent Documents 1 and 2).

In the conventional board apparatuses, the bridge structure is a separate body (separate component) from the wiring board and the plurality of dies.

### CITATION LIST

### PATENT DOCUMENT

Patent Document 1: Japanese Patent Application Laid-Open No. 2021-153172
Patent Document 2: Japanese Patent Application Laid-Open No. 2018-129528

### SUMMARY OF THE INVENTION

### PROBLEMS TO BE SOLVED BY THE INVENTION

Therefore, in the conventional board apparatus, there is room for improvement in improving productivity while suppressing deterioration of electrical characteristics.

Therefore, a main object of the present technology is to provide a board apparatus including a wiring layer that electrically connects a plurality of dies to each other, the board apparatus being capable of improving productivity while suppressing deterioration of electrical characteristics.

### SOLUTIONS TO PROBLEMS

The present technology provides a board apparatus including:
a wiring board; and
a wiring layer protruding from one surface of the wiring board and electrically connecting a plurality of dies to each other.

The one surface may be a flat surface.

The wiring board and each of the plurality of dies may be connected to each other via a first joint, and the wiring layer and each of the plurality of dies may be connected to each other via a second joint.

The second joints may be smaller than the first joints.

Each of the first and second joints may be a bump.

The first and second joints may be metal joints.

A ratio of a pitch of the first joints to a pitch of the second joints may be 2.0 or more and 5.0 or less.

The wiring layer may have a plan view shape corresponding to planar arrangement of at least two of the dies.

The plan view shape may be a quadrangle, an L-shape, a T-shape, a cross shape, a U-shape, a curved shape, or a combination of at least two of these.

The board apparatus may include a plurality of the wiring layers.

The wiring layer may include an insulating film and a wiring disposed inside the insulating film, and the insulating film may include a dielectric material.

The wiring board may include a substrate and a wiring disposed inside the substrate, and the substrate may include any of an organic substrate, an FOWLP, an FOPLP, a ceramic substrate, and a glass substrate.

The board apparatus may further include a heat spreader disposed across surfaces of the plurality of dies on a side opposite a wiring board side.

An underfill may be injected around the first joints between the wiring board and the plurality of dies and the second joints between the wiring layer and the plurality of dies. A plurality of dies and a board apparatus including a wiring board and a wiring layer protruding from one surface of the wiring board and electrically connecting at least two of the plurality of dies to each other may be included.

The present technology also provides an electronic device including:
an electronic apparatus including:
a plurality of dies; and
a board apparatus including a wiring board and a wiring layer protruding from one surface of the wiring board and electrically connecting at least two of the plurality of dies to each other; and
a circuit board on which the electronic apparatus is mounted.

The present technology also provides a method for manufacturing an electronic apparatus, the method including the steps of:
forming a wiring layer on a wiring board in a convex shape; and
connecting each of a plurality of dies and the wiring board to each other via a first joint and connecting each of the plurality of dies and the wiring layer to each other via a second joint.

The step of forming may include the sub-steps of: forming, on the wiring board, a layer in which a wiring is formed in a part, in an in-plane direction, of a photosensitive dielectric film; and removing another part, in the in-plane direction, of the photosensitive dielectric film from the layer through etching.

The step of forming may repeat, a plurality of times, a cycle including the sub-steps of: stacking a dielectric film on the wiring board; etching the dielectric film to form a groove; forming a metal film on the dielectric film in which the groove is formed; and grinding the metal film to form a wiring.

The present technology also provides a method for manufacturing an electronic device, the method including the steps of:
forming a wiring layer on a wiring board in a convex shape;
connecting each of a plurality of dies and the wiring board to each other via a first joint and connecting each of the plurality of dies and the wiring layer to each other via a second joint to generate an electronic apparatus; and
mounting the electronic apparatus on a circuit board.

### BRIEF DESCRIPTION OF DRAWINGS

Fig. 1 is a diagram schematically illustrating a cross-sectional configuration of an electronic apparatus according to an embodiment of the present technology.
Fig. 2 is a detailed diagram illustrating a cross-sectional configuration of a part of the electronic apparatus according to the embodiment of the present technology.
Fig. 3 is a diagram schematically illustrating a planar configuration of the electronic apparatus according to the embodiment of the present technology.
Fig. 4 is a detailed diagram illustrating a planar configuration of the electronic apparatus near a convex wiring layer according to the embodiment of the present technology.
Fig. 5 is a diagram for explaining a method for forming bumps of different sizes by a ball mounting method (first).
Fig. 6 is a diagram for explaining a method for forming bumps of different sizes by the ball mounting method (second).
Fig. 7 is a diagram for explaining a method for forming bumps of different sizes by a paste printing method.
Fig. 8 is a diagram for explaining a method for forming bumps of different sizes by a plating method.
Fig. 9A is a diagram schematically illustrating a planar configuration of an electronic apparatus according to Example 1 of the embodiment of the present technology. Fig. 9B is a diagram schematically illustrating a planar configuration of an electronic apparatus according to Example 2 of the embodiment of the present technology.
Fig. 10A is a diagram schematically illustrating a planar configuration of an electronic apparatus according to Example 3 of the embodiment of the present technology. Fig. 10B is a diagram schematically illustrating a planar configuration of an electronic apparatus according to Example 4 of the embodiment of the present technology.
Fig. 11A is a diagram schematically illustrating a planar configuration of an electronic apparatus according to Example 5 of the embodiment of the present technology. Fig. 11B is a diagram schematically illustrating a planar configuration of an electronic apparatus according to Example 6 of the embodiment of the present technology.
Fig. 12 is a flowchart for explaining an example of a method for manufacturing the electronic apparatus in Fig. 1.
Figs. 13A and 13B are cross-sectional views for each of the steps of the method for manufacturing the electronic apparatus in Fig. 1.
Figs. 14A and 14B are cross-sectional views for each of the steps of the method for manufacturing the electronic apparatus in Fig. 1.
Figs. 15A and 15B are cross-sectional views for each of the steps of the method for manufacturing the electronic apparatus in Fig. 1.
Figs. 16A and 16B are cross-sectional views for each of the steps of the method for manufacturing the electronic apparatus in Fig. 1.
Figs. 17A and 17B are cross-sectional views for each of the steps of the method for manufacturing the electronic apparatus in Fig. 1.
Fig. 18 is a cross-sectional view for each of the steps of the method for manufacturing the electronic apparatus in Fig. 1.
Fig. 19 is a diagram schematically illustrating a cross-sectional configuration of an electronic device including the electronic apparatus according to the embodiment of the present technology.
Fig. 20 is a flowchart for explaining an example of a method for manufacturing the electronic device in Fig. 19.
Figs. 21A and 21B are cross-sectional views for each of steps of the method for manufacturing the electronic device in Fig. 19.
Fig. 22 is a detailed diagram illustrating a cross-sectional configuration of a part of an electronic apparatus according to Example 7 of the embodiment of the present technology.
Fig. 23 is a detailed diagram illustrating a cross-sectional configuration of a part of an electronic apparatus according to Example 8 of the embodiment of the present technology.
Fig. 24 is a detailed diagram illustrating a cross-sectional configuration of a part of an electronic apparatus according to Example 9 of the embodiment of the present technology.
Fig. 25 is a detailed diagram illustrating a cross-sectional configuration of a part of an electronic apparatus according to Example 10 of the embodiment of the present technology.
Fig. 26 is a detailed diagram illustrating a cross-sectional configuration of a part of an electronic apparatus according to Example 11 of the embodiment of the present technology.
Fig. 27 is a detailed diagram illustrating a cross-sectional configuration of a part of an electronic apparatus according to Example 12 of the embodiment of the present technology.
Fig. 28 is a block diagram illustrating functions of an HPC that is an example of the electronic device including the electronic apparatus according to the embodiment of the present technology.
Fig. 29 is a diagram illustrating a configuration example of a node (computing server) in Fig. 28.
Fig. 30 is a diagram illustrating a mobile body on which the electronic device including the electronic apparatus according to the embodiment of the present technology is mounted.
Fig. 31 is a diagram schematically illustrating a cross-sectional configuration of a board apparatus included in the electronic apparatus according to the embodiment of the present technology.
Figs. 32A and 32B are a cross-sectional view and a plan view for each of steps of a damascene process.
Figs. 33A and 33B are a cross-sectional view and a plan view for each of the steps of the damascene process.
Figs. 34A and 34B are a cross-sectional view and a plan view for each of the steps of the damascene process.
Figs. 35A and 35B are a cross-sectional view and a plan view for each of the steps of the damascene process.
Figs. 36A and 36B are a cross-sectional view and a plan view for each of the steps of the damascene process.
Fig. 37 is a diagram illustrating an example of use of an electronic apparatus to which the present technology is applied.
Fig. 38 is a functional block diagram of an example of an electronic device including the electronic apparatus to which the present technology is applied.
Fig. 39 is a block diagram illustrating an example of a schematic configuration of a vehicle control system.
Fig. 40 is an explanatory diagram illustrating exemplary installation positions of an outside-vehicle information detecting section and an imaging section.

### MODE FOR CARRYING OUT THE INVENTION

A preferred embodiment of the present technology will be described in detail hereinafter with reference to the accompanying drawings. Note that, in the present specification and the drawings, components having substantially the same functional configuration are denoted by the same reference signs, and redundant description thereof is omitted. The embodiment described hereinafter illustrates a representative embodiment of the present technology, and the scope of the present technology is not narrowly interpreted by this embodiment. In the present specification, even in a case where it is described that a board apparatus, an electronic apparatus, an electronic device, a method for manufacturing the electronic apparatus, and a method for manufacturing the electronic device according to the present technology exhibit a plurality of effects, the board apparatus, the electronic apparatus, the electronic device, the method for manufacturing the electronic apparatus, and the method for manufacturing the electronic device according to the present technology may exhibit at least one effect. The effects described in the present specification are merely examples and are not limited, and other effects may also be produced.

Furthermore, the description will be given in the following order.

### 0. Introduction

### 1. Electronic Apparatus and Electronic Device Including Electronic Apparatus According to Embodiment of Present Technology

### <0. Introduction>

Board apparatuses capable of achieving broadband, wiring design flexibility, and power efficiency improvement by electrically connecting a plurality of freely laid dies to each other via a bridge structure arranged in a cavity of a wiring board are conventionally known (see, for example, Patent Documents 1 and 2).

In the conventional board apparatuses, however, there are disadvantages that a step of mounting the bridge structure as a component separate from the wiring board in the cavity of the wiring board is required and that a connection bump between the bridge structure and the wiring board is required, so that parasitic capacitance and resistance increase, leading to deterioration of electrical characteristics.

Therefore, as a result of intensive studies, the inventor has succeeded in eliminating the above-described disadvantages by integrally forming a convex wiring layer on a wiring board, that is, by providing a wiring layer protruding from one surface of the wiring board, in a board apparatus. Furthermore, the inventor has also developed an electronic apparatus including the board apparatus and an electronic device including the electronic apparatus in addition to the board apparatus to which this new knowledge is introduced.

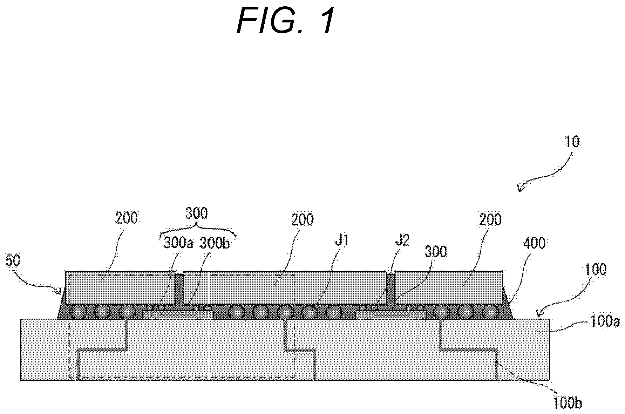

An electronic apparatus and an electronic device including the electronic apparatus according to an embodiment of the present technology will be described hereinafter in detail with reference to the drawings. In the following description, upper parts of cross-sectional views of Fig. 1 and the like will be described as upper sides, and lower parts of the cross-sectional views of Fig. 1 and the like will be described as lower sides for the sake of convenience.

### <1. Electronic Apparatus and Electronic Device Including Electronic Apparatus According to Embodiment of Present Technology>

### <<Configuration of Electronic Apparatus>>

### (Overall Configuration)

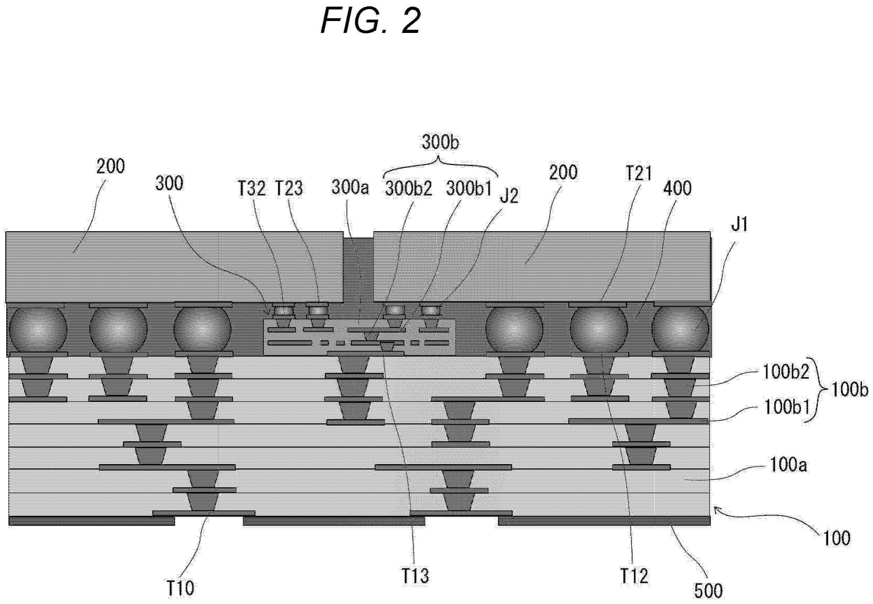

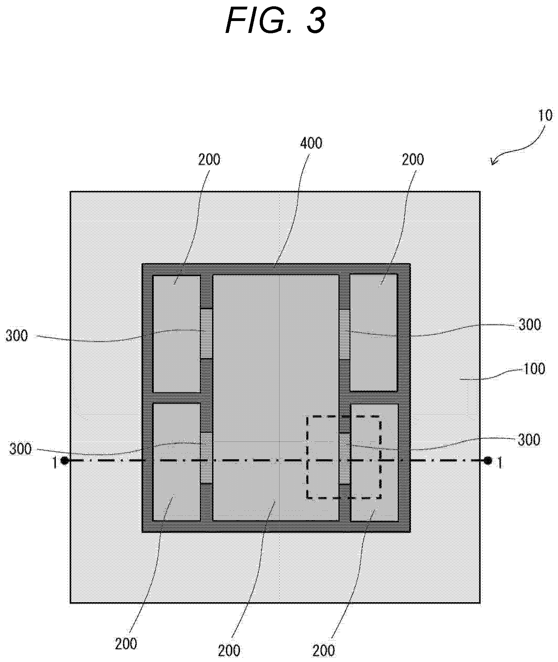

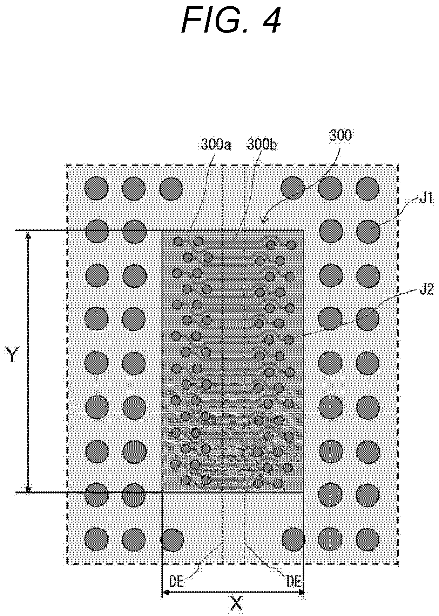

Fig. 1 is a diagram schematically illustrating a cross-sectional configuration of an electronic apparatus 10 according to the embodiment of the present technology. Fig. 2 is a detailed diagram illustrating a cross-sectional configuration of a part of the electronic apparatus 10 according to the embodiment of the present technology. Fig. 2 is a detailed diagram of a portion in Fig. 1 surrounded by a dash-dot line. Fig. 3 is a diagram schematically illustrating a planar configuration of the electronic apparatus 10 according to the embodiment of the present technology. Fig. 4 is a detailed diagram illustrating a planar configuration of the electronic apparatus 10 near the convex wiring layer according to the embodiment of the present technology. Fig. 4 is a detailed diagram of a cross section (horizontal cross section) of a portion in Fig. 3 surrounded by a broken line.

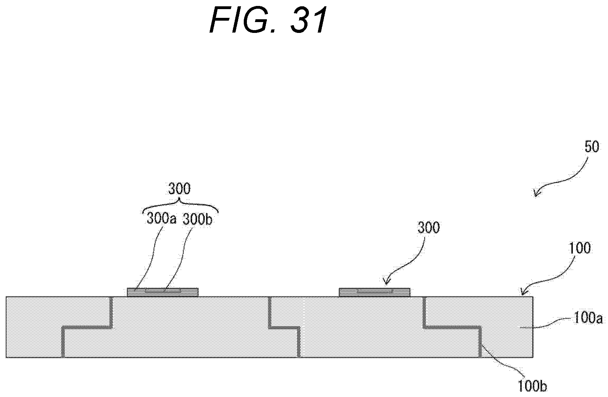

As illustrated in Fig. 1 as an example, an electronic apparatus 10-1 includes a board apparatus 50 (see Fig. 31) and a plurality of dies 200.

Each die 200 is, for example, an IC chip (a semiconductor chip on which an integrated circuit is formed) such as an imaging chip, a logic chip, a memory chip, a CPU chip, an AI chip, or an interface chip.

As an example, the board apparatus 50 includes a wiring board 100 and wiring layers 300 protruding from one surface (upper surface) of the wiring board 100 and electrically connecting the plurality of dies 200 to each other. The wiring layers 300 are formed integrally and convexly on one surface (upper surface) of the wiring board 100. Therefore, in the present specification, the wiring layers 300 will also be referred to as "convex wiring layers".

The one surface (upper surface) of the wiring board 100 is a flat surface. That is, a conventional cavity in which a bridge structure is disposed is not formed in the wiring board 100, and the convex wiring layer protrudes upward from the flat surface.

Here, as an example, five dies 200 are arranged in a layout as illustrated in Fig. 3. That is, as illustrated in Fig. 3, in the five dies 200, one large die 200 and each of four small dies 200 arranged around the large die 200 are electrically connected to each other via the wiring layer 300. That is, the board apparatus 50 includes a plurality of (for example, four) convex wiring layers as an example.

Returning to Fig. 1, the wiring board 100 and each of the plurality of dies 200 are connected to each other via first joints J1, and each of the wiring layers 300 and each of the plurality of dies 200 are connected to each other via second joints J2. As an example, a plurality (a large number) of first and second joints J1 and J2 is provided.

Each of the first and second joints J1 and J2 is, for example, a bump. The bump is, for example, a solder ball. The bump as the second joint J2 is smaller than the bump as the first joint J1. As a result, wiring connecting the dies 200 to each other can be densified, and wiring length can be reduced.

The wiring board 100 includes a board 100a and an internal wiring 100b disposed inside the board 100a. As an example, the board 100a is, for example, a prepreg in which fiber cloth is impregnated with a resin, an Ajinomoto build-up film (ABF, registered trademark), ceramic, glass, or an insulating film including a dielectric material such as polyimide (PI), polybenzoxazole (PBO), SiO₂, SiN, or SiON. The wiring 100b includes, for example, a metal such as Al, Cu, or W. As illustrated in Fig. 2, the internal wiring 100b includes lateral wires 100b1 and vias 100b2. As an example, the wiring board 100 has a multilayer structure in which interlayer insulating films, which are part of the board 100a in a thickness direction, and the lateral wires 100b1 are alternately stacked. The vertically adjacent lateral wires 100b1 are connected to each other via the vias 100b2.

Each wiring layer 300 includes an insulating film 300a and internal wiring 300b disposed inside the insulating film 300a. The insulating film 300a is an insulating film including a dielectric material such as polyimide (PI), polybenzoxazole (PBO), SiO₂, SiN, or SiON. The internal wiring 300b includes, for example, a metal such as Al, Cu, or W. The internal wiring 300b includes lateral wires 300b1 and vias 300b2. As an example, each wiring layer 300 has a multilayer structure in which interlayer insulating films, which are part of the insulating film 300a in the thickness direction, and the lateral wires 300b1 are alternately stacked. The vertically adjacent lateral wires 300b2 are connected to each other via the vias 300b2.

Die-side connection terminals T21 provided on a lower surface of each die 200 at positions facing the wiring board 100 and board-side connection terminals T12 provided on an upper surface of the wiring board 100 at positions corresponding to the die-side connection terminals T21 are connected to each other via the first joints J1. The die-side connection terminals T21 are connected to a circuit of the die 200. The board-side connection terminals T12 are connected to the internal wiring 100b of the wiring board 100.

Die-side connection terminals T23 provided on the lower surface of each die 200 at positions facing each wiring layer 300 and wiring layer-side connection terminals T32 provided on an upper surface of each wiring layer 300 at positions corresponding to the die-side connection terminals T23 are connected to each other via the second joints J2. The die-side connection terminals T23 are connected to the circuit of the die 200. The wiring layer-side connection terminals T32 are connected to the internal wiring 300b of the wiring layer 300.

Board-side connection terminals T13 are provided on an upper surface of the board 100a in regions where the wiring layers 300 are formed. The board-side connection terminals T13 are connected to the internal wiring 100b of the wiring board 100 and the internal wiring 300b of the wiring layers 300.

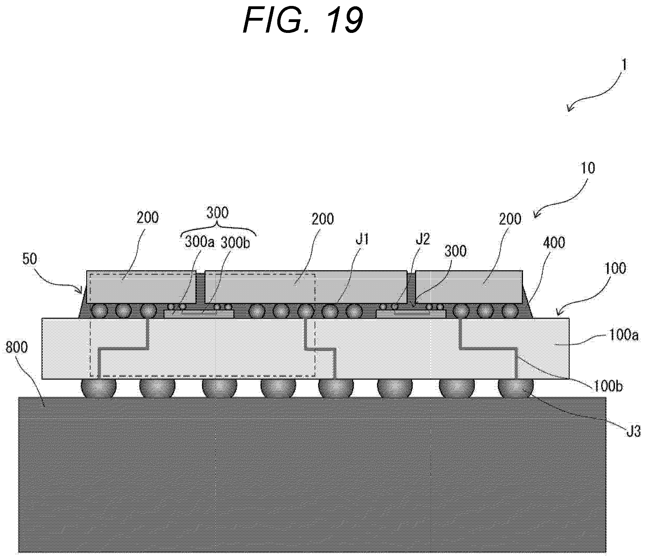

On a lower surface of the board 100a, board-side connection terminals T10 for connection to a circuit board 800 (see Fig. 19) are provided. The board-side connection terminals T10 are connected to the internal wiring 100b. A solder resist 500 is provided on the lower surface of the board 100a in such a way as to expose the board-side connection terminals T10.

As illustrated in Fig. 4, as an example, the convex wiring layer has a rectangular shape of about 2 mm × 6 mm(X = 2 mm, Y = 6 mm) in plan view. Height of the convex wiring layer is, for example, 60 µm to 70 µm.

A pitch (bump pitch) of the second joints J2 is, for example, 20 µm or more and 50 µm or less (for example, 40 um), and a pitch (bump pitch) of the first joints J1 is 100 µm or more. Note that size of the convex wiring layer and each bump pitch may be smaller or larger. In any case, a ratio of the pitch of the first joints J1 to the pitch of the second joints J2 is preferably 2.0 or more and 5.0 or less.

Here, a bump layout of the convex wiring layer is arranged in a staggered manner so that wiring can be easily performed with surface layer wiring, but may be arranged, for example, in a grid, instead. In addition, since the convex wiring layer has a multilayer structure, the dies 200 may be connected to each other using, for example, second and third layers other than a surface layer.

Underfill 400 is injected around the first joints J1 between the wiring board 100 and the plurality of dies 200 and around the second joints J2 between the wiring layers 300 and the plurality of dies 200. As a result, it is possible to improve bump connection reliability against a temperature stress accompanying an operation and a stop of each die 200. The underfill 400 may contain a filler such as silicon oxide having a small linear expansion coefficient mainly using an epoxy resin as a main agent. Note that, in the electronic apparatus 10, the underfill 400 is not essential.

### (Method for Forming First and Second Joints)

There are roughly three types of methods for forming the first and second joints J1 and J2, that is, bumps having different sizes, namely a ball mounting method, a paste printing method, and a plating method.

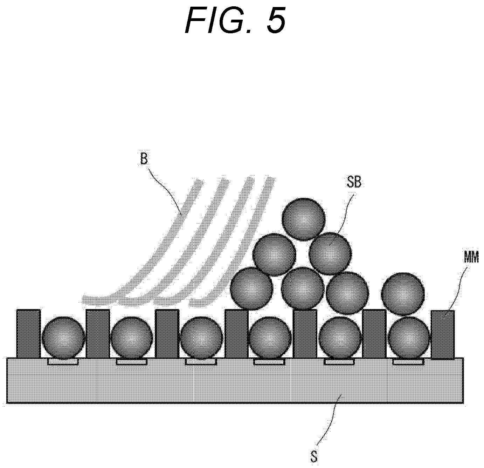

Fig. 5 is a diagram for explaining a method for forming bumps of different sizes by the ball mounting method (first). In the ball mounting method illustrated in Fig. 5, solder balls SB having sizes corresponding to sizes of openings of a metal mask MM disposed on a substrate S are inserted, using a brush B, into the openings of a plurality of types (for example, two types) having different sizes, thereby forming solder bumps having different sizes on the substrate S.

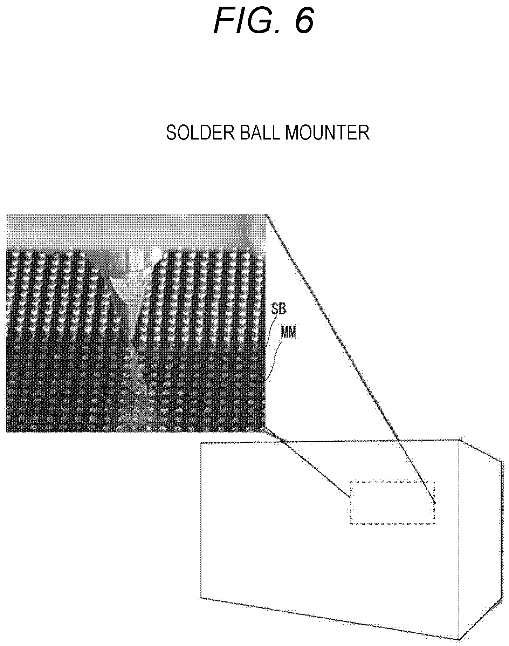

Fig. 6 is a diagram for explaining a method for forming bumps of different sizes by the ball mounting method (second). In the ball mounting method illustrated in Fig. 6, solder balls SB having sizes corresponding to sizes of openings of a metal mask MM are discharged from a solder ball mounting head of a solder ball mounter disposed on a substrate to the metal mask MM, the openings being of a plurality of types (for example, two types) having different sizes, so that solder bumps having different sizes are formed on the substrate.

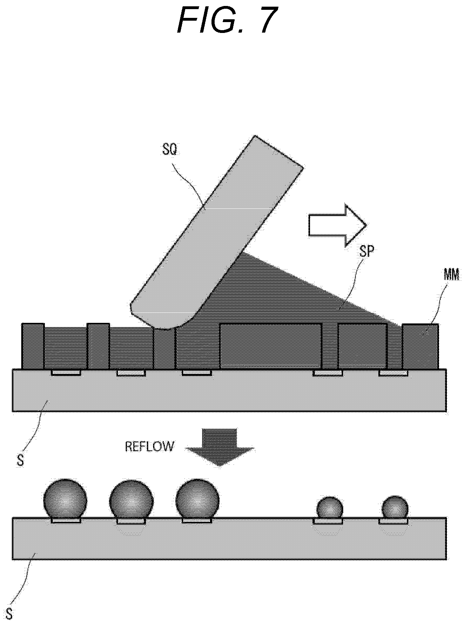

Fig. 7 is a diagram for explaining a method for forming bumps of different sizes by the paste printing method. In the paste printing method illustrated in Fig. 7, solder paste SP is printed on a substrate S using a squeegee SQ with a metal mask MM having a plurality of types (for example, two types) of openings having different sizes as a mask, and then reflowed to form solder bumps having different sizes on the substrate S.

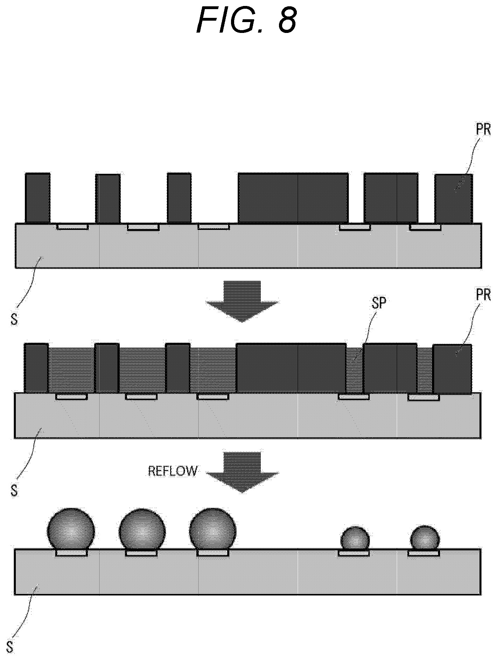

Fig. 8 is a diagram for explaining a method for forming bumps of different sizes by the plating method. In the plating method illustrated in Fig. 8, solder paste SP is grown on a substrate S by an electrolytic plating method or an electroless plating method using a photoresist PR having a plurality of types (for example, two types) of openings having different sizes as a mask, and then reflowed to form solder bumps having different sizes on the substrate S.

### (Variations of Plan View Shape of Wiring Layer)

Each wiring layer 300 preferably has a plan view shape corresponding to planar arrangement of at least two dies 200 corresponding to the wiring layer 300, for example, as in Examples 1 to 6 below. Examples of the plan view shape include a quadrangle, an L-shape, a T-shape, a cross shape, a U-shape, a curved shape, and a combination of at least two of these.

### (Example 1)

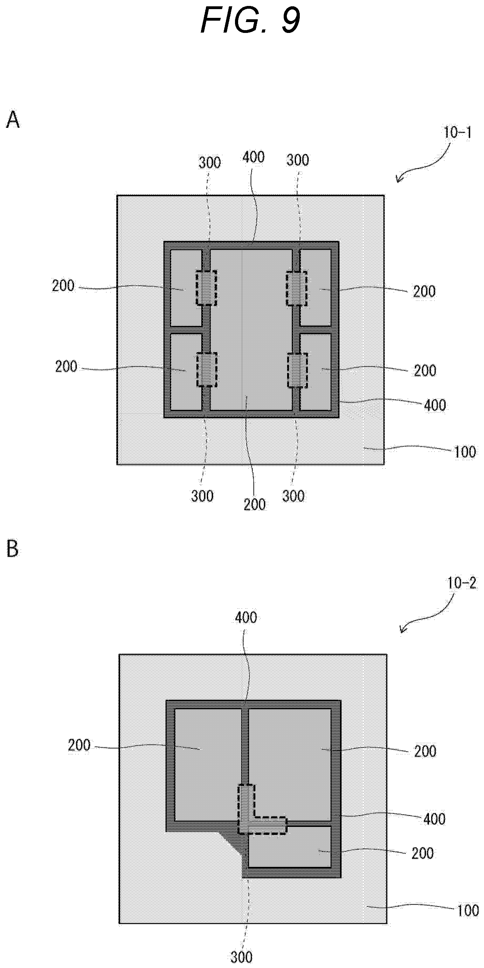

Fig. 9A is a diagram schematically illustrating a planar configuration of an electronic apparatus 10-1 according to Example 1 of the embodiment of the present technology. In the electronic apparatus 10-1, a large die 200 and each of two small dies 200 arranged on both sides thereof are connected to each other via wiring layers 300 having a quadrangular shape (planar line-of-sight shape) in plan view. Here, a total of four wiring layers 300 are provided.

### (Example 2)

Fig. 9B is a diagram schematically illustrating a planar configuration of an electronic apparatus 10-2 according to Example 2 of the embodiment of the present technology. In the electronic apparatus 10-2, a plurality of (for example, three) dies 200 arranged in an L-shape in plan view and having a rectangular shape in plan view is connected to each other via a wiring layer 300 having an L-shape in plan view.

### (Example 3)

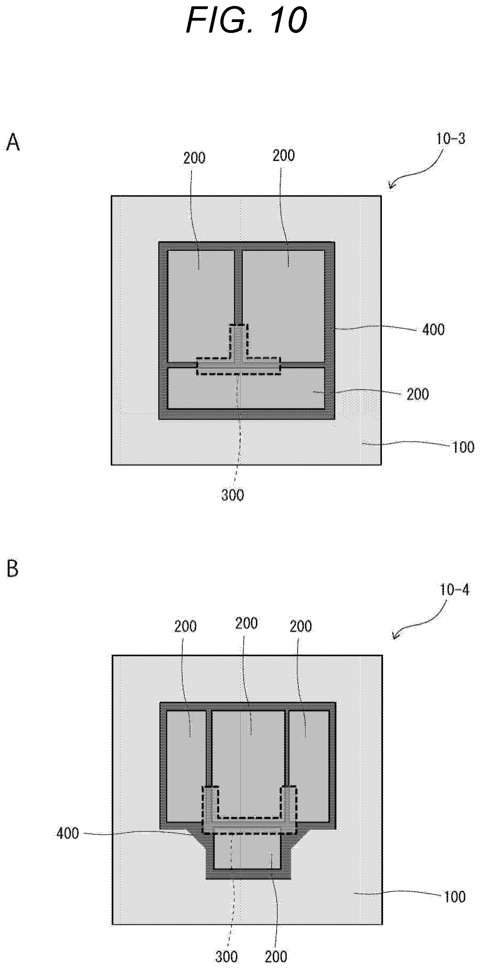

Fig. 10A is a diagram schematically illustrating a planar configuration of an electronic apparatus 10-3 according to Example 3 of the embodiment of the present technology. In the electronic apparatus 10-3, a plurality of (for example, three) dies 200 having a rectangular shape in plan view and arranged in such a way as to form a gap having a T-shape in plan view is connected to each other via a wiring layer 300 having a T-shape in plan view.

### (Example 4)

Fig. 10B is a diagram schematically illustrating a planar configuration of an electronic apparatus 10-4 according to Example 4 of the embodiment of the present technology. In the electronic apparatus 10-4, a plurality of (for example, four) dies 200 having a rectangular shape in plan view and arranged in a T-shape in plan view (arranged in such a way as to form a gap having a U-shape in plan view) is connected to each other via a wiring layer 300 having a U-shape in plan view.

### (Example 5)

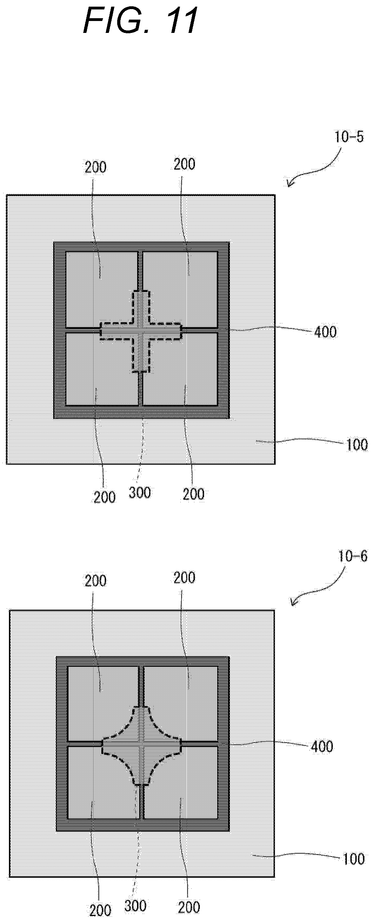

Fig. 11A is a diagram schematically illustrating a planar configuration of an electronic apparatus 10-5 according to Example 5 of the embodiment of the present technology. In the electronic apparatus 10-5, a plurality of (for example, four) dies 200 having a square shape in plan view arranged in such a way as to form a gap having a cross shape in plan view (arranged in a square lattice shape in plan view) is connected to each other via a wiring layer 300 having a cross shape in plan view.

### (Example 6)

Fig. 11B is a diagram schematically illustrating a planar configuration of an electronic apparatus 10-6 according to Example 6 of the embodiment of the present technology. In the electronic apparatus 10-6, a plurality (for example, four) of dies 200 having a square shape in plan view (arranged in a square lattice shape in plan view) arranged in such a way as to form a gap having a cross shape in plan view is connected to each other via a wiring layer 300 having a petal shape protruding in four directions in plan view.

### <<Effects of Board Apparatus and Electronic Apparatus>>

The board apparatus 50 included in the electronic apparatus 10 (including the electronic apparatuses 10-1 to 10-6 according to Examples 1 to 6) according to the embodiment of the present technology described above includes the wiring board 100 and the wiring layers 300 protruding from one surface of the wiring board 100 and electrically connecting the plurality of dies 200 to each other.

In this case, a step of mounting the wiring layers 300 on the wiring board 100 is unnecessary, and connection bumps between the wiring layers 300 and the wiring board 100 are unnecessary, which suppresses an increase in parasitic capacitance and resistance.

As a result, with the board apparatus 50, it is possible to provide a board apparatus including wiring layers that electrically connect a plurality of dies to each other and capable of improving productivity while suppressing deterioration of electrical characteristics.

The electronic apparatus 10 according to the embodiment of the present technology includes the plurality of dies 200 and the board apparatus 50. As a result, it is possible to provide an electronic apparatus capable of improving productivity while suppressing deterioration of electrical characteristics.

### <<Method for Manufacturing Electronic Apparatus>>

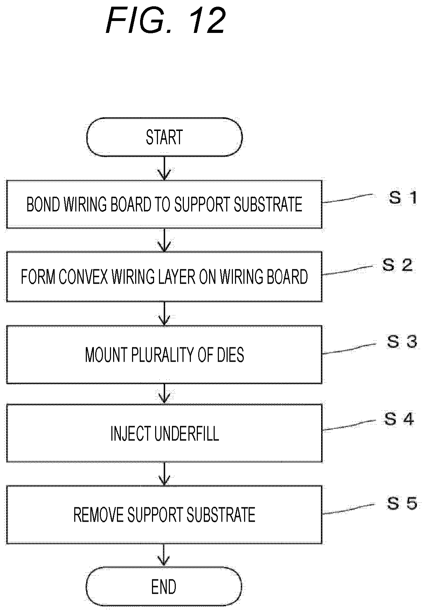

A method for manufacturing the electronic apparatus 10 (including the electronic apparatuses 10-1 to 10-6 in Examples 1 to 6) according to the embodiment of the present technology will be described hereinafter with reference to a flowchart of Fig. 12 and the like.

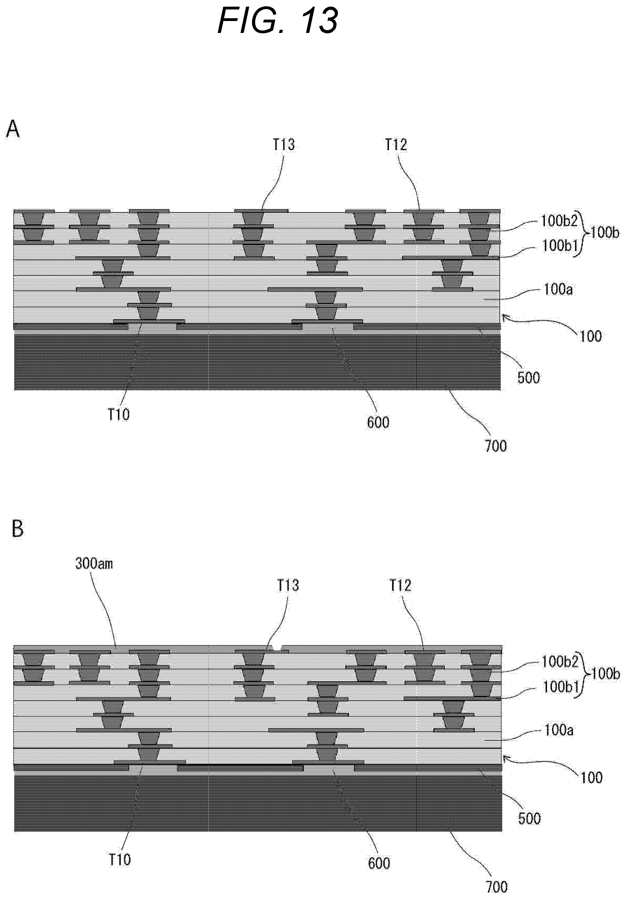

In a first step S1, the wiring board 100 is bonded to a support substrate 700 (see Fig. 13A). Specifically, the wiring board 100 is bonded to the support substrate 700 with a peelable adhesive 600. The adhesive 600 may be any adhesive as long as it is used for a peeling method capable of releasing the bonding between the wiring board 100 and the support substrate 700, such as laser peeling, mechanical peeling, and thermal peeling.

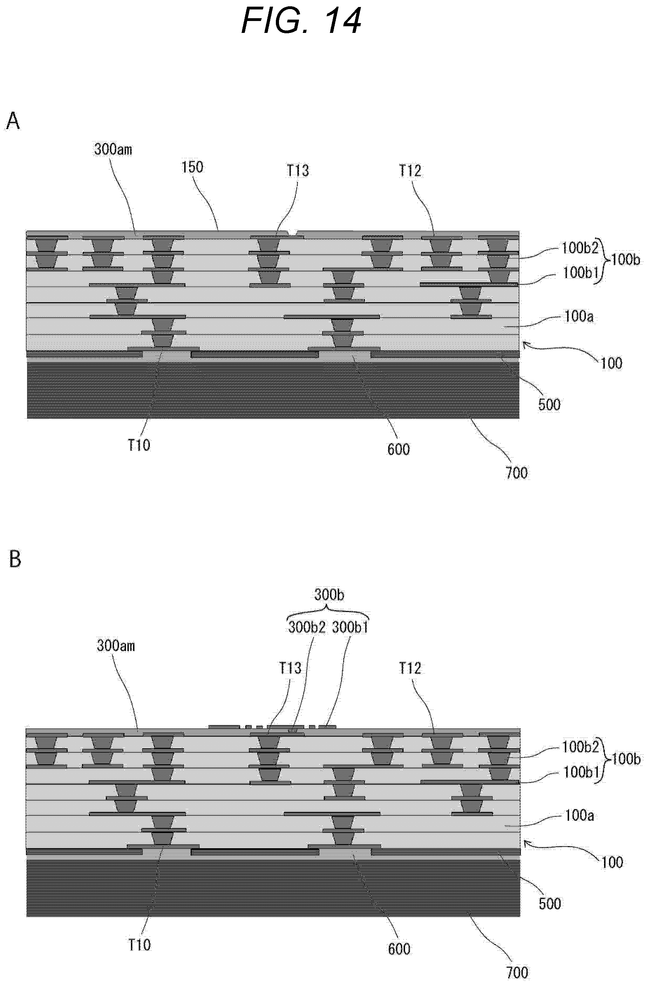

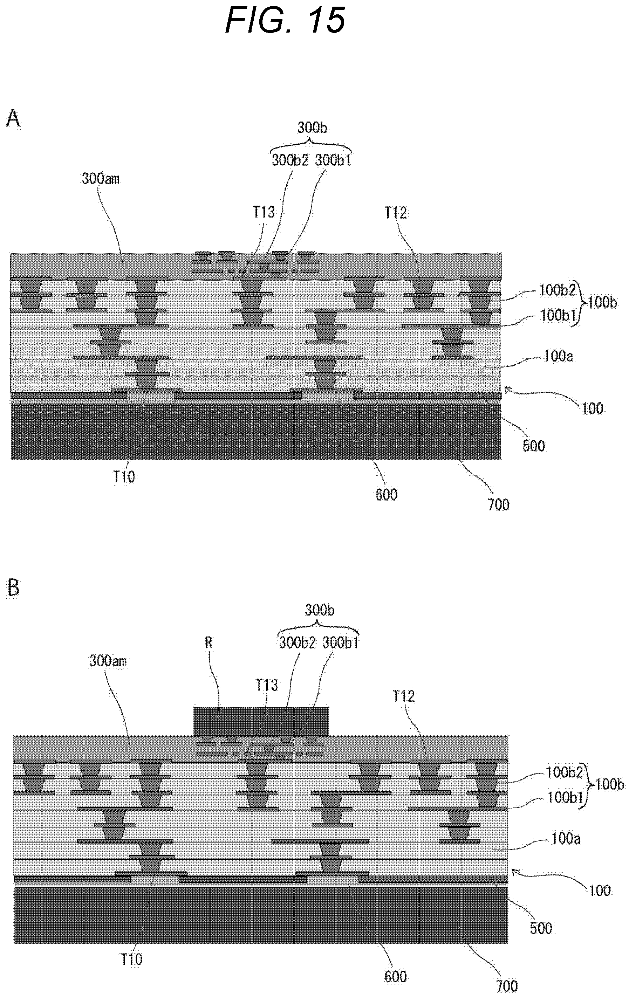

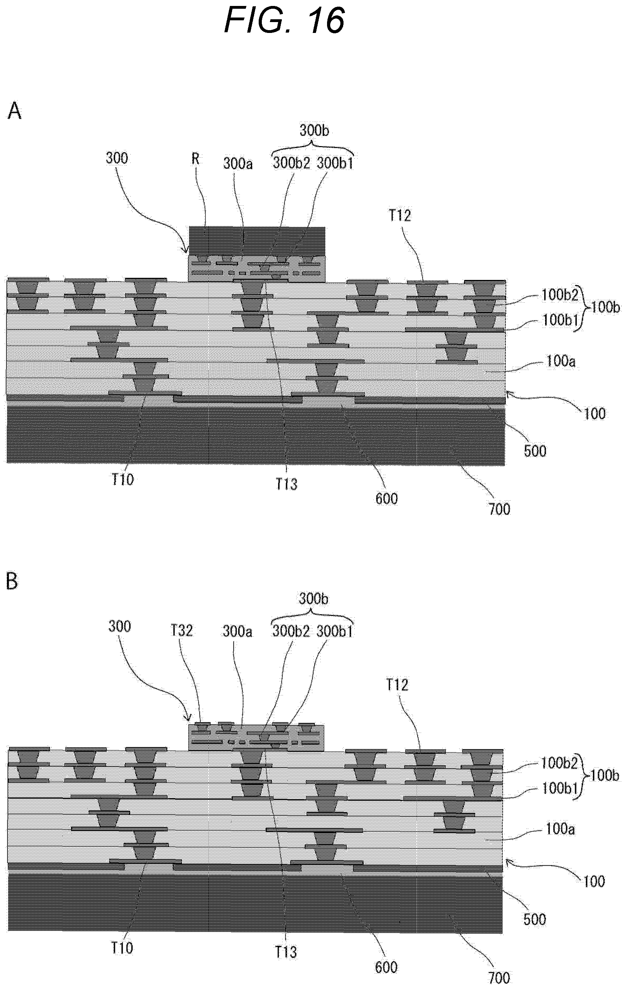

In a next step S2, a convex wiring layer is formed on the wiring board 100. Specifically, first, a photosensitive dielectric material 300am is applied to an entire surface of the wiring board 100, and via holes of the convex wiring layer are formed through exposure and development (see Fig. 13B). Next, a seed layer 150 is formed through seed sputtering (see Fig. 14A). A material of the seed layer 150 is, for example, a titanium copper alloy (Ti/Cu) or the like. Next, vias 300b2 and lateral wires 300b1 of a first layer of the convex wiring layer are formed through a redistribution layer (RDL) plating step. Thereafter, unnecessary portions of the seed layer 150 are removed through etching (see Fig. 14B). A step of forming a photosensitive dielectric material 300am, vias 300b2, and lateral wires 300b1 is then repeated to form a wiring layer having a multilayer structure (see Fig. 15A). Next, a resist R is applied to an entire surface of the photosensitive dielectric material 300am, and the resist R other than the resist R covering regions where the convex wiring layer is to be formed through exposure and development is removed (see Fig. 15B). Next, using the resist R as a mask, the photosensitive dielectric material 300am other than the photosensitive dielectric material 300am of the convex wiring layer is removed through etching (see Fig. 16A). Next, the resist R on the convex wiring layer is removed (see Fig. 16B).

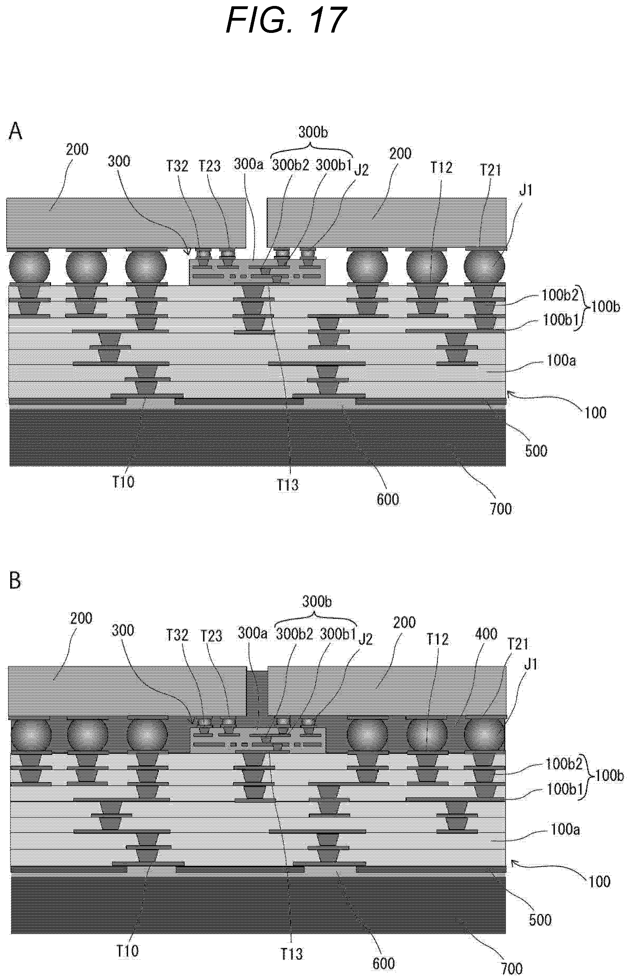

In a next step S3, a plurality of dies 200 is mounted (see Fig. 17A). Specifically, for example, each die 200 and the wiring board 100 are bonded to each other via the first joints J1, and each die 200 and the wiring layer 300 are bonded to each other via the second joints J2 through mass reflow or thermal compression bonding (TCB).

In a next step S4, the underfill 400 is injected (see Fig. 17B). Specifically, the underfill 400 is injected around the first joints J1 between the wiring board 100 and the plurality of dies 200 and around the second joints J2 between the wiring layer 300 and the plurality of dies 200.

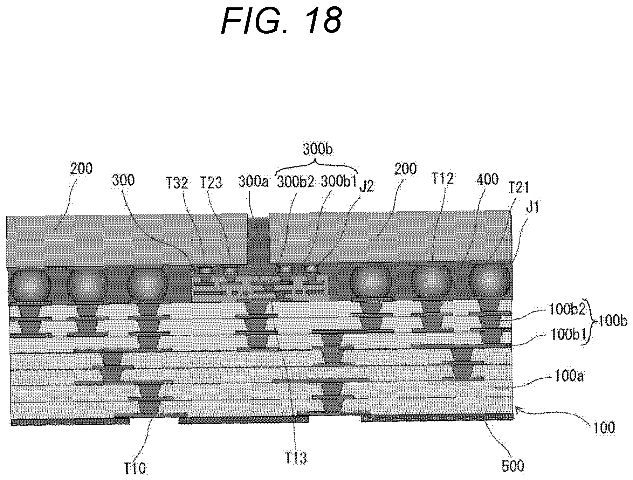

In a final step S5, the support substrate 700 is removed (see Fig. 18). Specifically, the support substrate 700 is peeled off from the wiring board 100.

Note that, for an insulating film 300a of the convex wiring layer, a non-photosensitive dielectric material may be used instead of the photosensitive dielectric material. In this case, the internal wiring 300b of the convex wiring layer can be formed through a damascene process, but fine wiring (line and space (L/S) = 1/1 µm or less) can be formed as compared with the plating method. In addition, a glass material may be used for the insulating film 300a of the convex wiring layer. In this case, a mismatch of a linear expansion coefficient between the convex wiring layer and the dies 200 is reduced, and the bump connection reliability improves. A method for manufacturing the electronic apparatus 10 using a photosensitive dielectric material will be referred to as "manufacturing method 1", and a method for manufacturing the electronic apparatus 10 using a non-photosensitive dielectric material will be referred to as "manufacturing method 2" hereinafter.

### <<Effects of Method for Manufacturing Electronic Apparatus>>

The method for manufacturing the electronic apparatus 10 (including the electronic apparatuses 10-1 to 10-6 in Examples 1 to 6) described above includes the steps of forming the wiring layers 300 on the wiring board 100 in convex shapes, and connecting each of the plurality of dies 200 and the wiring board 100 to each other via the first joints J1 and connecting each of the plurality of dies 200 and the wiring layer 300 to each other via the second joints J2.

With the method for manufacturing the electronic apparatus 10, since it is not necessary to mount the wiring layers 300 on the wiring board 100, productivity can be improved.

In manufacturing method 1 of the electronic apparatus 10, the step of forming the wiring layers 300 on the wiring board 100 in convex shapes includes a sub-step of forming, on the wiring board 100, a layer in which the internal wiring 300b is formed in parts, in an in-plane direction, of a photosensitive dielectric film (photosensitive dielectric material 300am), and a sub-step of removing other parts, in the in-plane direction, of the photosensitive dielectric film (photosensitive dielectric material 300am) from the layer through etching.

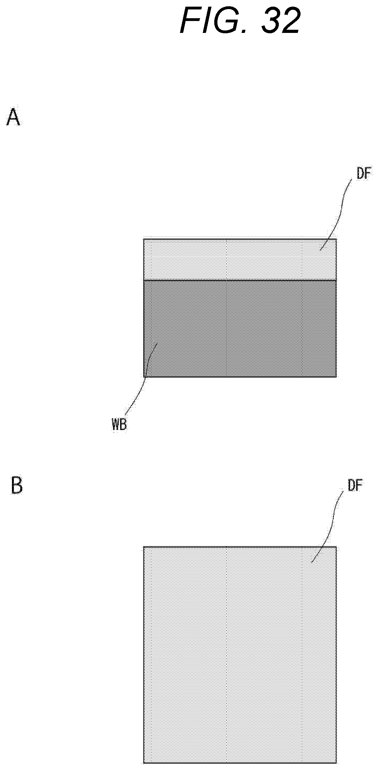

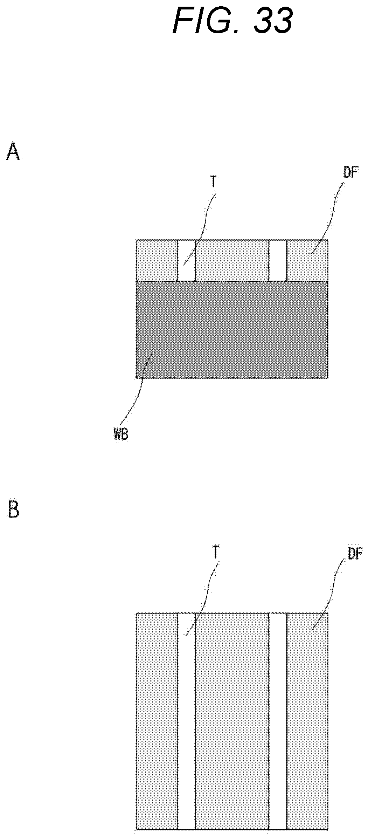

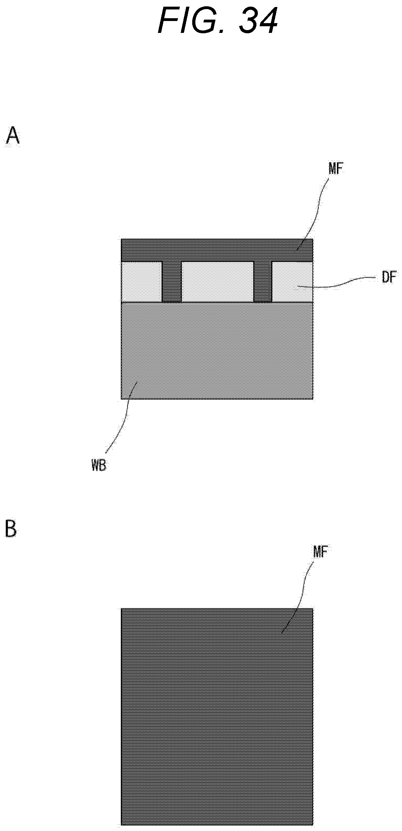

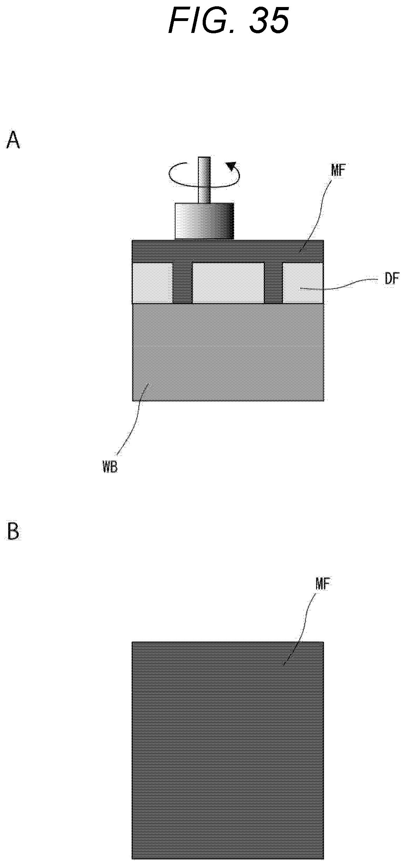

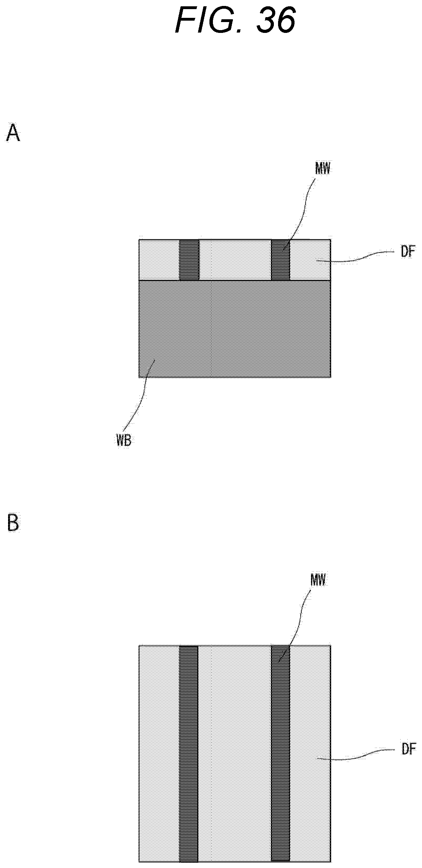

In manufacturing method 2 of the electronic apparatus 10, the step of forming the wiring layers 300 on the wiring board 100 in convex shapes repeats, a plurality of times, a cycle (damascene process) including a sub-step of stacking a dielectric film DF (non-photosensitive dielectric material) on a wiring board WB (see a cross-sectional view of Fig. 32A and a plan view of Fig. 32B), a sub-step of etching the dielectric film DF to form a groove T (see a cross-sectional view of Fig. 33A and a plan view of Fig. 33B), a sub-step of forming a metal film MF on the dielectric film DF in which the groove T is formed (see a cross-sectional view of Fig. 34A and a plan view of Fig. 34B), and a sub-step of grinding the metal film MF (see a cross-sectional view of Fig. 35A and a plan view of Fig. 35B) to form a metal wiring (MW) (see a cross-sectional view of Fig. 36A and a plan view of Fig. 36B).

### <<Configuration of Electronic Device>>

Fig. 19 is a diagram schematically illustrating a cross-sectional configuration of an electronic device 1 including an electronic apparatus 10 according to the embodiment of the present technology.

As illustrated in Fig. 19, the electronic device 1 includes the electronic apparatus 10 and the circuit board 800 on which the electronic apparatus 10 is mounted.

The electronic apparatus 10 and the circuit board 800 are electrically connected to each other via third joints J3. The third joints J3 are, for example, solder bumps. Note that the third joints J3 may be or may not be a component of the electronic apparatus 10.

### <<Method for Manufacturing Electronic Device>>

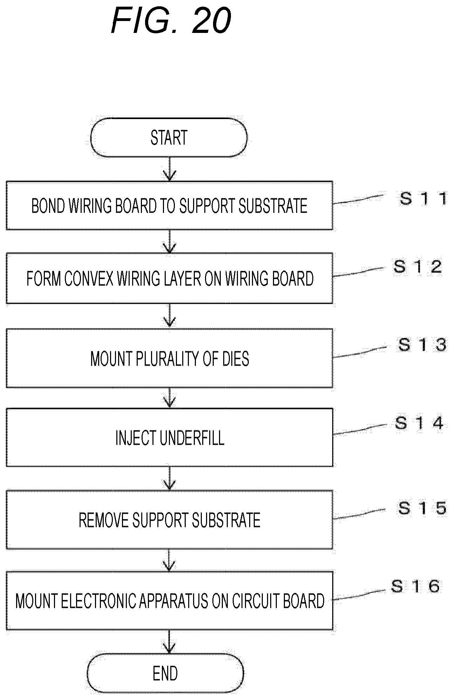

A method for manufacturing the electronic device 1 will be described hereinafter with reference to a flowchart of Fig. 20 and the like.

Steps S11 to S15 in Fig. 20 are similar to steps S1 to S5 in Fig. 12.

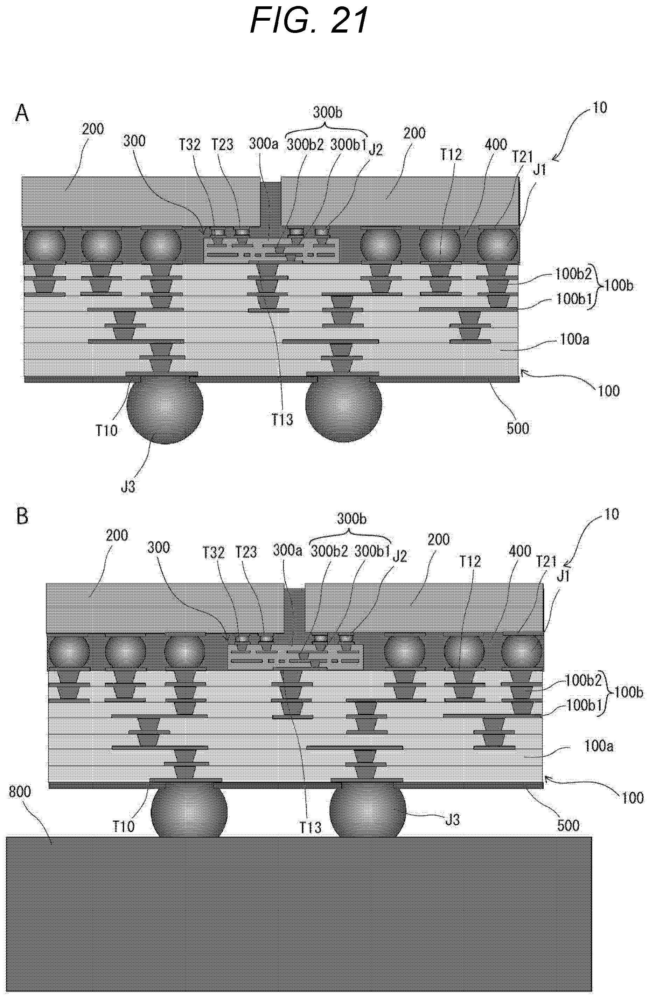

In a final step S16, the electronic apparatus 10 is mounted on the circuit board 800. Specifically, first, solder balls to be the third joints J3 are mounted on the board-side connection terminals T10 of the electronic apparatus 10 (see Fig. 21A). Next, the electronic apparatus 10 and the circuit board 800 are electrically connected to each other via the third joints J3 through, for example, mass reflow or thermal compression bonding (TCB) (see Fig. 21B).

### <<Effects of Electronic Device and Method for Manufacturing Electronic Device>>

The electronic device 1 including the electronic apparatus 10 according to the embodiment of the present technology described above includes the electronic apparatus 10 and the circuit board 800 on which the electronic apparatus 10 is mounted. As a result, it is possible to provide an electronic device capable of improving productivity while suppressing deterioration of electrical characteristics.

The method for manufacturing the electronic device 1 according to the present technology includes a step of forming the wiring layers 300 on the wiring board 100 in convex shapes, a step of connecting each of the plurality of dies 200 and the wiring board 100 to each other via the first joints J1 and connecting each of the plurality of dies 200 and the wiring layers 300 to each other via the second joints J2 to produce the electronic apparatus 10, and a step of mounting the electronic apparatus 10 on the circuit board 800.

With the method for manufacturing the electronic device 1, since it is not necessary to mount the wiring layers 300 on the wiring board 100, productivity can be improved.

### (Example 7)

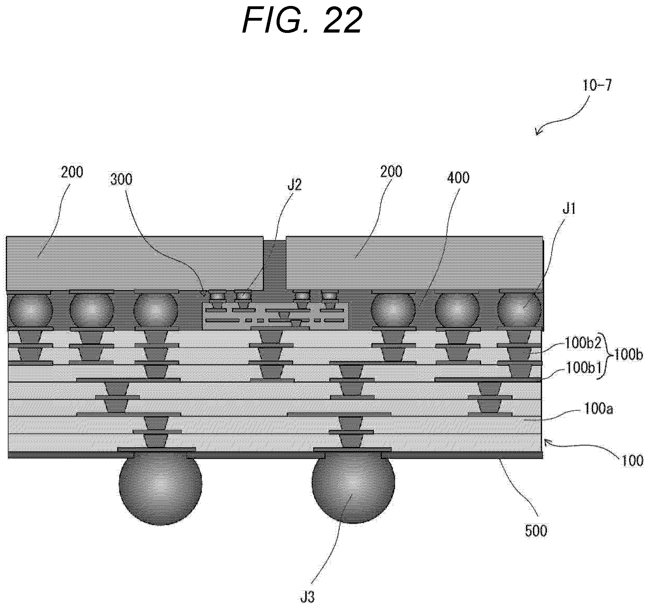

Fig. 22 is a detailed diagram illustrating a cross-sectional configuration of a part of an electronic apparatus 10-7 according to Example 7 of the embodiment of the present technology. In the electronic apparatus 10-7 illustrated in Fig. 22, a substrate 100a of a wiring board 100 includes an organic substrate. With the electronic apparatus 10-7, since the substrate 100a includes the organic substrate, cost reduction can be achieved.

### (Example 8)

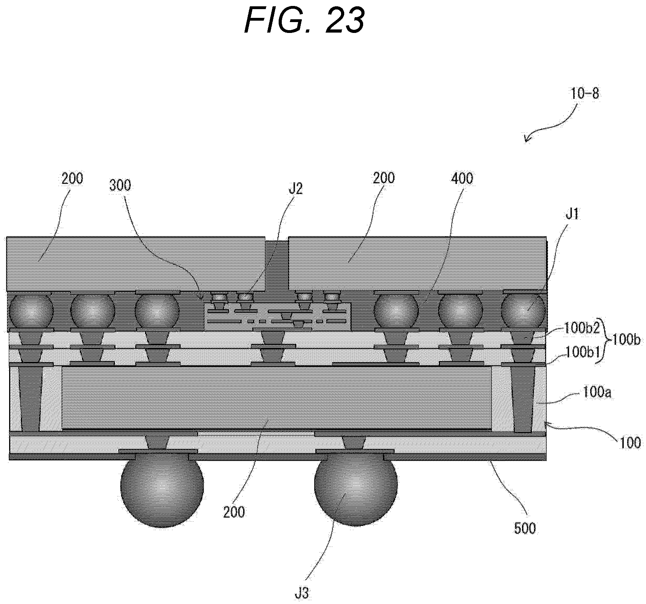

Fig. 23 is a detailed diagram illustrating a cross-sectional configuration of a part of an electronic apparatus 10-8 according to Example 8 of the embodiment of the present technology. In the electronic apparatus 10-8 illustrated in Fig. 23, the substrate 100a of the wiring board 100 includes a fan-out wafer-level package (FOWLP) or a fan-out panel-level package (FOPLP). In a method for manufacturing the electronic apparatus 10-8, manufacturing steps after the step of forming the convex wiring layer on the wiring board 100 are similar to those of the manufacturing method illustrated in Fig. 12.

The electronic apparatus 10-8 includes dies 200 (also referred to as "internal dies") disposed inside the wiring board 100 in addition to the dies 200 disposed over the wiring board 100 and the wiring layers 300. The internal dies are connected to the internal wiring 100b. With the electronic apparatus 10-8, since the dies 200 can be incorporated in the wiring board 100, wiring length between the dies 200 can be reduced to improve electrical characteristics, and downsizing can be achieved.

### (Example 9)

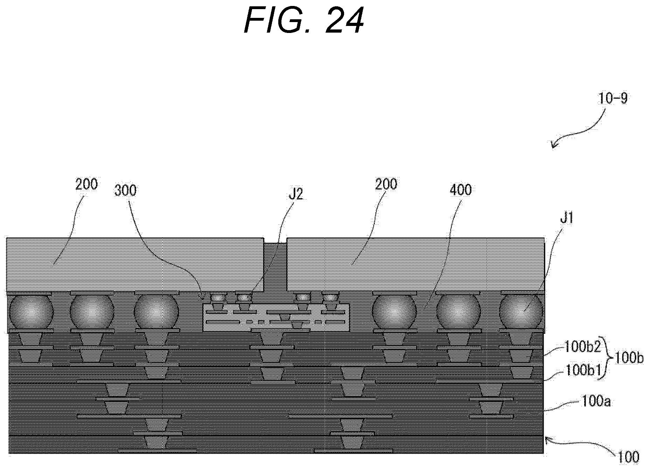

Fig. 24 is a detailed diagram illustrating a cross-sectional configuration of a part of an electronic apparatus 10-9 according to Example 9 of the embodiment of the present technology. In the electronic apparatus 10-9 illustrated in Fig. 24, the substrate 100a of the wiring board 100 includes a ceramic substrate. In a method for manufacturing the electronic apparatus 10-9, manufacturing steps after the step of forming the convex wiring layer on the wiring board 100 is similar to the manufacturing method illustrated in Fig. 12. With the electronic apparatus 10-9, since the substrate 100a includes the ceramic substrate, it is excellent in high thermal conductivity, low thermal expansion coefficient, low dielectric constant, and chemical resistance.

### (Example 10)

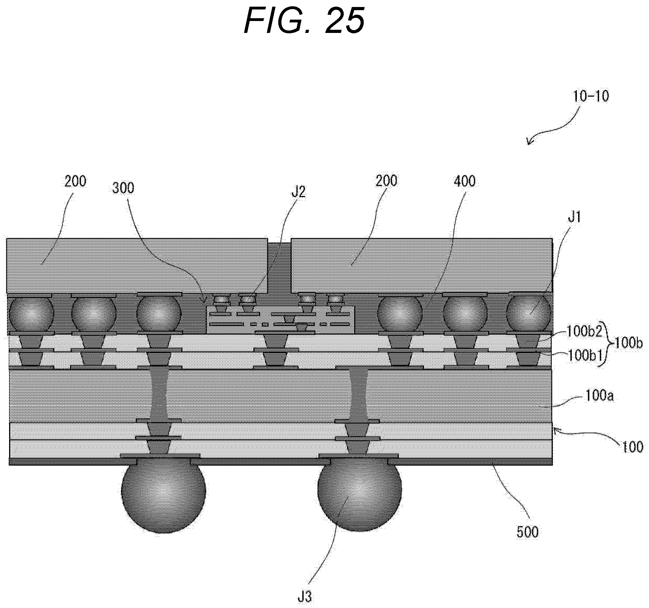

Fig. 25 is a detailed diagram illustrating a cross-sectional configuration of a part of an electronic apparatus 10-10 according to Example 10 of the embodiment of the present technology. In the electronic apparatus 10-10 illustrated in Fig. 25, the substrate 100a of the wiring board 100 includes a glass substrate (for example, borosilicate glass). In a method for manufacturing the electronic apparatus 10-10, manufacturing steps after the step of forming the convex wiring layer on the wiring board 100 is similar to the manufacturing method illustrated in Fig. 12. With the electronic apparatus 10-10, since the substrate 100a of the wiring board 100 includes a glass substrate (for example, borosilicate glass), heat resistance and impact resistance are excellent. In addition, with the electronic apparatus 10-10, since the glass substrate (for example, borosilicate glass) included in the substrate 100a has a thermal expansion coefficient close to that of silicon (silicon: 2.4 ppm/K, borosilicate glass: 3.2 to 3.8 ppm/K), connection reliability of the first and third joints J1 and J3 improves.

### (Example 11)

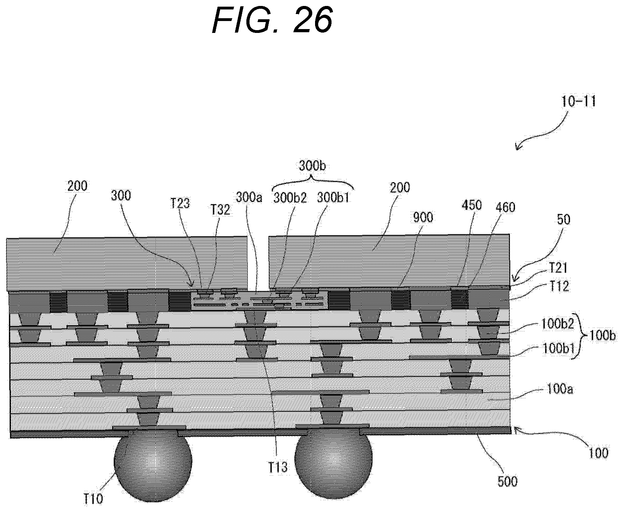

Fig. 26 is a detailed diagram illustrating a cross-sectional configuration of a part of an electronic apparatus 10-11 according to Example 11 of the embodiment of the present technology. In the electronic apparatus 10-11 illustrated in Fig. 26, each of the first and second joints is a metal joint. In the electronic apparatus 10-11, each of the first and second joints is, for example, a Cu-Cu joint.

A method for performing Cu-Cu hybrid bonding will be described hereinafter. First, a SiO₂ film 450 is formed on surfaces (lower surfaces) of the die-side connection terminals T21 and T23 including Cu through plasma CVD, and planarized through chemical mechanical polishing (CMP). A thermosetting resin 460 is applied to the board apparatus 50 in which the convex wiring layer is provided on the wiring board 100 in such a way as to eliminate unevenness of surfaces (upper surfaces), and the board apparatus 50 is planarized through CMP in a B-stage (semi-cured state). Thereafter, annealing (200°C to 300°C) is performed to metal-bond (solid-phase diffusion) the die-side connection terminals T21 and the board-side connection terminals T12 to each other, and metal-bond (solid-phase diffusion) the die-side connection terminals T23 and the wiring layer-side connection terminals T32 to each other. As a result of this annealing, the thermosetting resin 460 formed on the board apparatus 50 and bonded to the SiO₂ film 450 formed in the dies 200 enters a C-stage (fully cured state). As described above, since the dies 200 and the board apparatus 50 are bonded to each other through metal bonding, connection bumps are unnecessary, and wiring inductance and wiring resistance are reduced, which produces an effect of improving electrical characteristics.

Note that the thermosetting resin 460 formed on the board apparatus 50 may be C-staged before being bonded to the dies 200. Furthermore, the resin material of the surfaces of the board apparatus 50 connected to the dies 200 is not limited to the thermosetting resin, and may be, for example, any of a thermoplastic resin, a photosensitive dielectric material, and a non-photosensitive dielectric material.

### (Example 12)

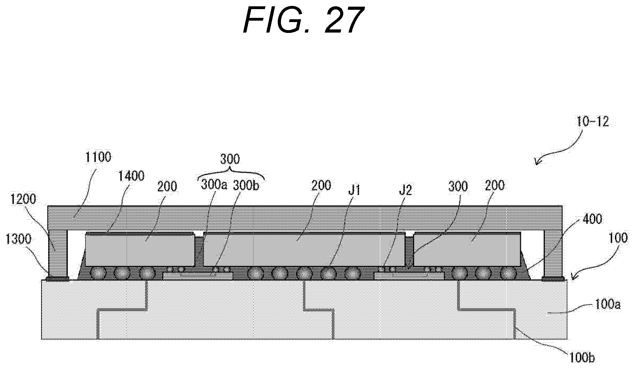

Fig. 27 is a detailed diagram illustrating a cross-sectional configuration of a part of an electronic apparatus 10-12 according to Example 12 of the embodiment of the present technology.

The electronic apparatus 10-12 further includes a heat spreader 1100 disposed across surfaces of the plurality of dies 200 on a side opposite a wiring board 100 side. This enables efficient thermal diffusion from each die 200.

By sandwiching a thermal interface material 1400 (TIM) between the dies 200 and the heat spreader 1100, contact thermal resistance of an interface can be reduced. Examples of the TIM include alumina (Al₂O₃), aluminum nitride (AlN), and a liquid metal (gallium or a gallium alloy).

The heat spreader 1100 is supported on the wiring board 100 via a support member 1200. A lower end of the support member 1200 is fixed to the wiring board 100 with an adhesive 1300.

Parts of the configuration of the electronic apparatus 10 according to the embodiment described above and the electronic apparatuses 10-1 to 10-12 according to Examples 1 to 12 thereof may be combined without causing a contradiction. In addition, a shape, size, the number, and the like of each of the dies 200 and the convex wiring layer in the electronic apparatus 10 can be appropriately changed. For example, the number of dies 200 in the electronic apparatus 10 may be two or more, and the number of convex wiring layers may be one or more.

### (HPC)

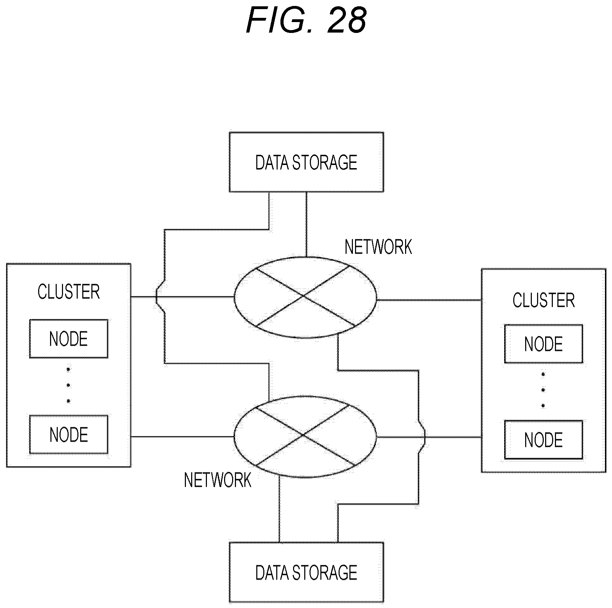

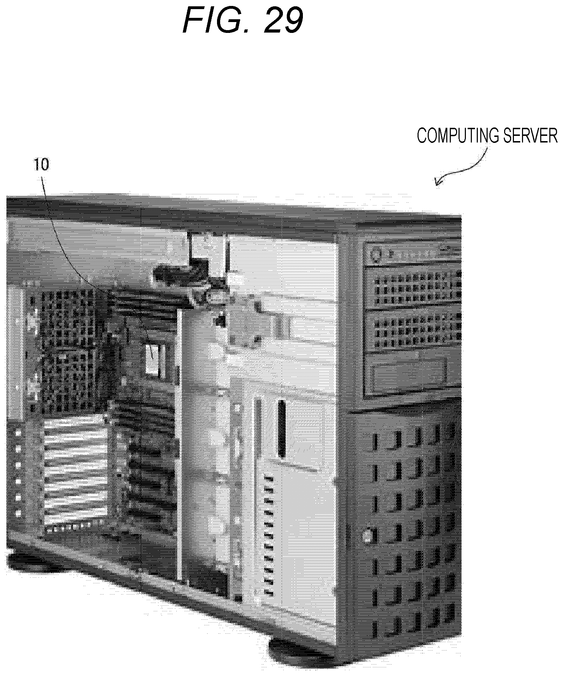

Fig. 28 is a block diagram illustrating functions of a high-performance computing (HPC), which is an example of an electronic device including the electronic apparatus 10 (for example, the electronic apparatuses 10-1 to 10-12 according to Examples 1 to 12) according to the embodiment. Fig. 29 is a diagram illustrating a configuration example of a node (computing server) of Fig. 28.

The electronic apparatus 10 used for the HPC constitutes hardware such as a central processing unit (CPU), a graphics processing unit (GPU), and a field programmable gate array (FPGA).

The functions of the HPC are roughly divided into a computing server (see Fig. 29), a network, and a data storage. The electronic apparatus 10 may be used to implement at least one of a computing server, a network, or a data storage.

In order to build an HPC architecture, as illustrated in Fig. 28, a plurality of (for example, several to several thousand) computing servers constituting a cluster are networked. There is a plurality of clusters. Each computing server of the cluster is called a node. Since each node of the cluster operates in parallel with the other nodes, processing speed improves, and the HPC can be achieved. A software program and an algorithm are simultaneously executed on the servers in the cluster. The cluster is networked to the data storage and an output is obtained. These components operate seamlessly and perform various tasks.

For the HPC to operate at full performance, each component needs to maintain the same speed as the other components. For example, the data storage needs to be able to feed and ingest data to and from the computing servers as soon as processing starts. Similarly, the network needs to be able to support high speed data transfer between the computing servers and the data storage. These performances can be obtained by using the electronic apparatus 10 (including the electronic apparatuses 10-1 to 10-12 in Examples 1 to 12) for the components of the HPC.

### <Example of Application to Mobile Body>

The technology according to the present disclosure (present technology) can be applied to various products. For example, the technology of the present disclosure may be achieved in the form of a device to be mounted on a mobile object of any kind, such as an automobile, an electric vehicle, a hybrid electric vehicle, a motorcycle, a bicycle, a personal mobility, an airplane, a drone, a vessel, or a robot.

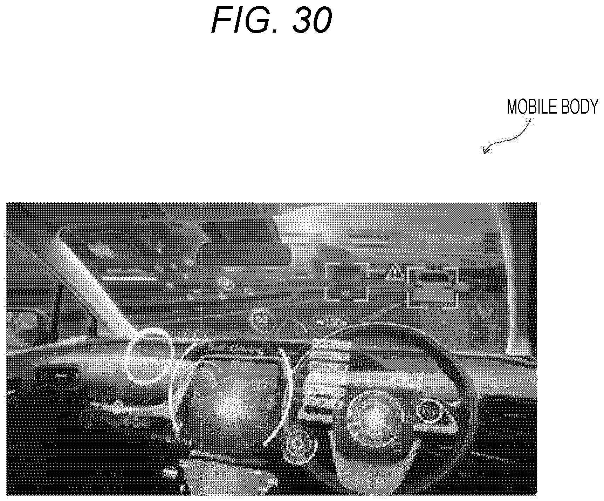

Fig. 30 is a diagram illustrating an automobile as an example of a mobile body on which an electronic device including the electronic apparatus 10 (including the electronic apparatuses 10-1 to 10-12 in Examples 1 to 12) according to the embodiment of the present technology is mounted. The electronic apparatus 10 is used as, for example, a component of a sensing unit of an automobile. The sensing unit is used, for example, for automated driving control.

### (Example of Use of Electronic Device)

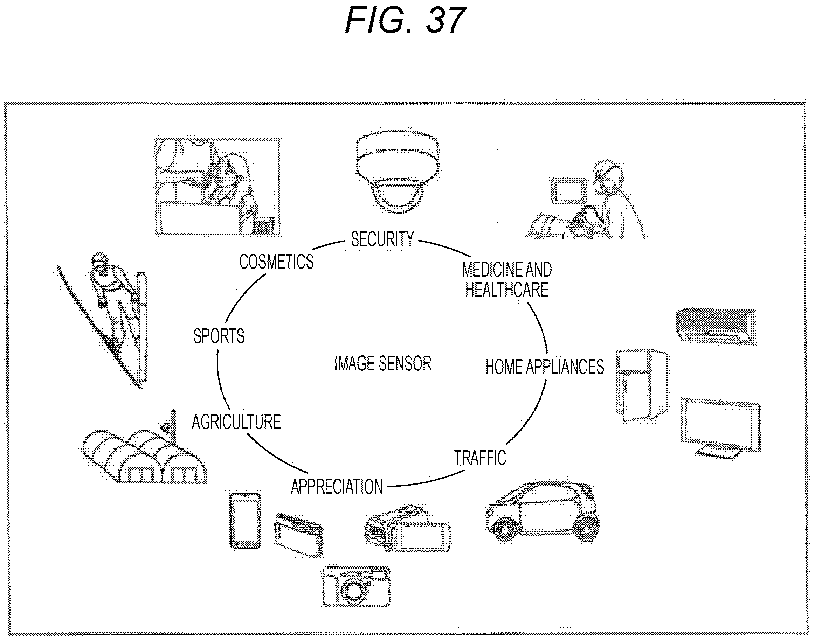

Fig. 37 is a diagram illustrating an example of use in a case where the board apparatus, the electronic apparatus, or the electronic device according to the present technology constitutes at least a part of a solid-state imaging device (image sensor). The case of constituting at least a part of the image sensor is, for example, a case where the plurality of dies 200 includes an imaging chip, a logic chip, a memory chip, an AI chip, an interface chip, and the like on which a solid-state imaging device is mounted.

The electronic apparatus 10 according to the embodiment of the present technology (for example, the electronic apparatuses 1 to 12 according to Examples 1 to 12), the board apparatus 50 included in the electronic apparatus 10 and the electronic device including the electronic apparatus 10 can be used, for example, in various cases of sensing light such as visible light, infrared light, ultraviolet light, and X-rays as follows. That is, as illustrated in Fig. 37, for example, the present invention can be used in a device used in a field of appreciation in which an image provided for appreciation is captured, a field of transportation, a field of home electric appliances, a field of medical and healthcare, a field of security, a field of beauty, a field of sports, a field of agriculture, and the like.

Specifically, in the field of appreciation, for example, any of the board apparatus, the electronic apparatus, and the electronic device according to the present technology can be used for an apparatus for capturing images to be provided for appreciation, such as a digital camera, a smartphone, or a mobile phone with a camera function.

In the field of traffic, for example, for safe driving such as automatic stop, recognition of a driver's condition, or the like, any of the board apparatus, the electronic apparatus, and the electronic device according to the present technology can be used for an apparatus used for traffic, such as an in-vehicle sensor for capturing an image of the front, rear, surroundings, inside, or the like of an automobile, a monitoring camera for monitoring traveling vehicles and roads, or a distance measuring sensor for measuring a distance between vehicles or the like.

In the field of home appliances, for example, in order to capture an image of a gesture of a user and perform a device operation according to the gesture, any of the board apparatus, the electronic apparatus, and the electronic device according to the present technology can be used in an apparatus provided for home appliances such as a television receiver, a refrigerator, and an air conditioner.

In the field of medical and healthcare, for example, any of the board apparatus, the electronic apparatus, and the electronic device according to the present technology can be used for an apparatus provided for medical and healthcare, such as an endoscope and an apparatus that performs angiography by receiving infrared light.

In the field of security, for example, any of the board apparatus, the electronic apparatus, and the electronic device according to the present technology can be used for an apparatus provided for security, such as a monitoring camera for crime prevention or a camera for person authentication.

In the field of beauty, for example, any of the board apparatus, the electronic apparatus, and the electronic device according to the present technology can be used in an apparatus provided for beauty, such as a skin measuring instrument for photographing skin or a microscope for photographing a scalp.

In the field of sports, for example, any one of the board apparatus, the electronic apparatus, and the electronic device according to the present technology can be used in an apparatus provided for sports, such as an action camera or a wearable camera for sports or the like.

In the field of agriculture, for example, any of the board apparatus, the electronic apparatus, and the electronic device according to the present technology can be used for an apparatus used for agriculture, such as a camera for monitoring a condition of fields and crops.

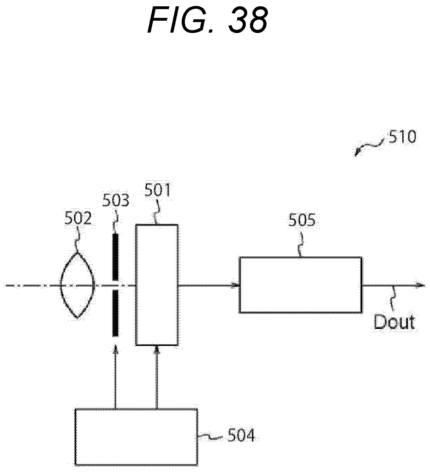

Next, examples of use of the board apparatus, the electronic apparatus, and the electronic device according to the present technology will be specifically described. For example, the board apparatus, the electronic apparatus, and the electronic device according to the present technology can be employed for any type of electronic device having an imaging function, such as a camera system typified by a digital still camera or a video camera, or a mobile phone having an imaging function, as at least a part of the solid-state imaging device 501. Fig. 38 illustrates a schematic configuration of an electronic device 510 (camera) as an example. The electronic device 510 is a video camera capable of capturing a still image or a moving image, for example, and includes the solid-state imaging device 501, an optical system (optical lens) 502, a shutter device 503, a drive unit 504 that drives the solid-state imaging device 501 and the shutter device 503, and a signal processing unit 505.

The optical system 502 guides image light (incident light) from a subject to a pixel region of the solid-state imaging device 501. The optical system 502 may include a plurality of optical lenses. The shutter device 503 controls a light radiation period and a light shielding period regarding the solid-state imaging device 501. The drive unit 504 controls a transfer operation of the solid-state imaging device 501 and a shutter operation of the shutter device 503. The signal processing unit 505 performs various types of signal processing on a signal output from the solid-state imaging device 501. A video signal Dout after the signal processing is stored in a storage medium such as a memory or output to a monitor and the like.

### (Other Examples of Use of Board Apparatus, Electronic Apparatus, and Electronic Device to Which Present Technology Is Applied)

The board apparatus, the electronic apparatus, and the electronic device according to the present technology can also be employed for, for example, at least a part of another electronic device that detects light, such as a time-of-flight (TOF) sensor. In a case where the photodetection device is applied to a TOF sensor, for example, the photodetection device can be applied to a distance image sensor by a direct TOF measurement method, or a distance image sensor by an indirect TOF measurement method. In the distance image sensor by the direct TOF measurement method, arrival timing of photons is directly obtained in a time domain in each pixel. Therefore, a light pulse having a short pulse width is transmitted, and an electrical pulse is generated by a receiver that responds at a high speed. The present disclosure can be applied to the receiver at that time. Furthermore, by the indirect TOF method, a flight time of light is measured with a semiconductor element structure in which detection and an accumulation amount of carriers generated by light change depending on the arrival timing of light.

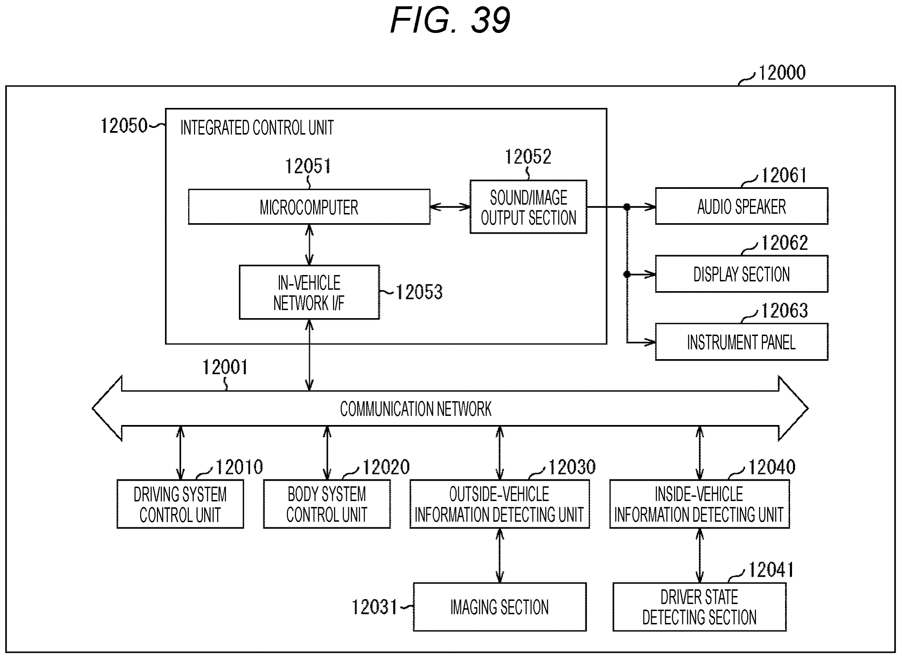

Fig. 39 is a block diagram illustrating an example of schematic configuration of a vehicle control system as an example of a mobile body control system to which the technology according to the present disclosure can be applied.

A vehicle control system 12000 includes a plurality of electronic control units connected via a communication network 12001. In the example illustrated in Fig. 39, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of apparatuses related to the drive system of the vehicle according to various programs. For example, the driving system control unit 12010 functions as a control apparatus of a driving force generating apparatus for generating a driving force of the vehicle such as an internal combustion engine or a driving motor, a driving force transmitting mechanism for transmitting the driving force to wheels, a steering mechanism for adjusting a steering angle of the vehicle, a braking apparatus for generating a braking force of the vehicle, and the like.

The body system control unit 12020 controls operations of various apparatuses mounted on the vehicle body according to various programs. For example, the body system control unit 12020 functions as a control apparatus of a keyless entry system, a smart key system, a power window apparatus, or various lamps such as a headlamp, a backup lamp, a brake lamp, a turn signal, or a fog lamp. In this case, radio waves transmitted from a portable device that substitutes for a key or signals of various switches can be input to the body system control unit 12020. The body system control unit 12020 receives input of these radio waves or signals, and controls a door lock apparatus, a power window apparatus, a lamp, and the like of the vehicle.

The outside-vehicle information detecting unit 12030 detects information outside the vehicle on which the vehicle control system 12000 is mounted. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information inside the vehicle. For example, a driver state detecting section 12041 that detects a state of a driver is connected to the in-vehicle information detecting unit 12040. The driver state detecting section 12041 includes, for example, a camera that images the driver, and the in-vehicle information detecting unit 12040 may calculate the degree of fatigue or the degree of concentration of the driver or may determine whether or not the driver is dozing off on the basis of the detection information input from the driver state detecting section 12041.

The microcomputer 12051 can calculate a control target value of the driving force generating apparatus, the steering mechanism, or the braking apparatus on the basis of the information inside and outside the vehicle acquired by the outside-vehicle information detecting unit 12030 or the in-vehicle information detecting unit 12040, and output a control command to the driving system control unit 12010. For example, the microcomputer 12051 can perform cooperative control for the purpose of implementing functions of an advanced driver assistance system (ADAS) including collision avoidance or shock mitigation of the vehicle, follow-up traveling based on an inter-vehicle distance, vehicle speed maintaining traveling, vehicle collision warning, vehicle lane departure warning, or the like.

Furthermore, the microcomputer 12051 controls the driving force generating apparatus, the steering mechanism, the braking apparatus, or the like on the basis of the information around the vehicle acquired by the outside-vehicle information detecting unit 12030 or the in-vehicle information detecting unit 12040, thereby performing cooperative control for the purpose of automated driving or the like in which the vehicle autonomously travels without depending on the operation of the driver.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control for the purpose of preventing glare, such as switching from a high beam to a low beam, by controlling the headlamp according to the position of a preceding vehicle or an oncoming vehicle detected by the outside-vehicle information detecting unit 12030.

The sound/image output section 12052 transmits an output signal of at least one of a sound or an image to an output apparatus capable of visually or auditorily notifying a passenger of the vehicle or the outside of the vehicle of information. In the example of Fig. 39, an audio speaker 12061, a display section 12062, and an instrument panel 12063 are illustrated as the output device. The display section 12062 may include, for example, at least one of an on-board display or a head-up display.

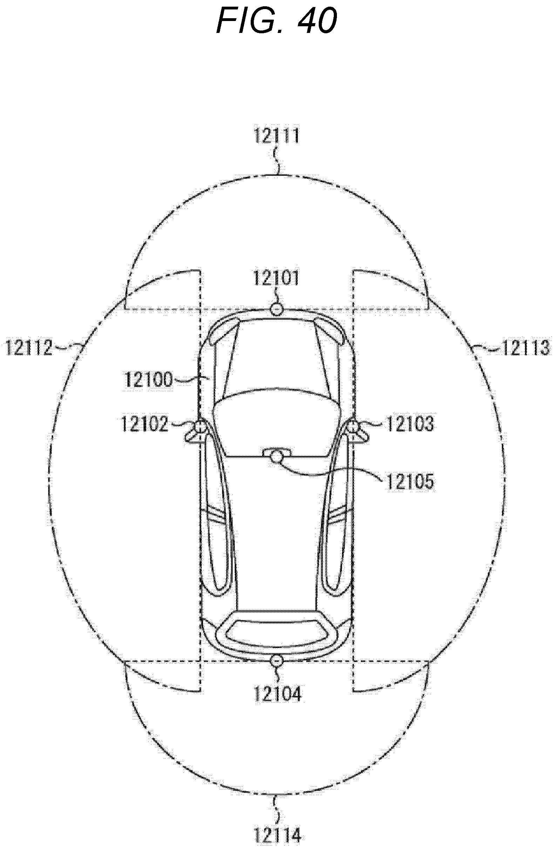

Fig. 40 is a diagram illustrating an example of an installation position of the imaging section 12031.

In Fig. 40, a vehicle 12100 includes imaging sections 12101, 12102, 12103, 12104, and 12105 as the imaging section 12031.

The imaging sections 12101, 12102, 12103, 12104, 12105 are provided, for example, at positions such as a front nose, a sideview mirror, a rear bumper, a back door, and an upper portion of a windshield in the interior of a vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly images of sides of the vehicle 12100. The imaging section 12104 provided to the rear bumper or the back door obtains mainly an image of the rear of the vehicle 12100. The forward images obtained by the imaging sections 12101 and 12105 are used mainly to detect a preceding vehicle, a pedestrian, an obstacle, a traffic signal, a traffic sign, a lane, or the like.

Note that Fig. 40 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Furthermore, the microcomputer 12051 can set a following distance to be maintained in front of a preceding vehicle in advance, and perform automatic brake control (including following stop control), automatic acceleration control (including following start control), or the like. As described above, it is possible to perform cooperative control for the purpose of automated driving or the like in which the vehicle autonomously travels without depending on the operation of the driver.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle, and when the collision risk is a set value or more and there is a possibility of collision, the microcomputer can perform driving assistance for collision avoidance by outputting an alarm to the driver via the audio speaker 12061 or the display section 12062 or performing forced deceleration or avoidance steering via the driving system control unit 12010.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure (present technology) can be applied has been described above. The technology according to the present disclosure can be applied to the imaging section 12031 and the like, for example, out of the configurations described above. Specifically, for example, the solid-state imaging device 111 in the present disclosure can be applied to the imaging section 12031. By applying the technology according to the present disclosure to the imaging section 12031, it is possible to increase yield and reduce costs related to the manufacturing.

Furthermore, the present technology can also have the following configurations.
(1) A board apparatus including:
   a wiring board; and
   a wiring layer protruding from one surface of the wiring board and electrically connecting a plurality of dies to each other.
(2) The board apparatus according to (1), in which the one surface is a flat surface.
(3) The board apparatus according to (1) or (2), in which
   the wiring board and each of the plurality of dies are connected to each other via a first joint, and
   the wiring layer and each of the plurality of dies are connected to each other via a second joint.
(4) The board apparatus according to (3), in which the second joints are smaller than the first joints.
(5) The board apparatus according to (3) or (4), in which each of the first and second joints is a bump.
(6) The board apparatus according to any one of (3) to (5), in which
   the first and second joints are metal joints.
(7) The board apparatus according to any one of (3) to (6), in which a ratio of a pitch of the first joints to a pitch of the second joints is 2.0 or more and 5.0 or less.
(8) The board apparatus according to any one of (1) to (7), in which the wiring layer has a plan view shape corresponding to planar arrangement of at least two of the dies.
(9) The board apparatus according to (8), in which the plan view shape is a quadrangle, an L-shape, a T-shape, a cross shape, a U-shape, a curved shape, or a combination of at least two of these.
(10) The board apparatus according to any one of (1) to (9), further including: a plurality of the wiring layers.
(11) The board apparatus according to any one of (1) to (10), in which
   the wiring layer includes:
   an insulating film; and
   a wiring disposed inside the insulating film, and
   the insulating film includes a dielectric material.
(12) The board apparatus according to any one of (1) to (11), in which
   the wiring board includes:
   a substrate; and
   a wiring disposed inside the substrate, and
   the substrate includes any of an organic substrate, an FOWLP, an FOPLP, a ceramic substrate, and a glass substrate.
(13) The board apparatus according to (1), further including: a heat spreader disposed across surfaces of the plurality of dies on a side opposite a wiring board side.
(14) The board apparatus according to any one of (3) to (13), in which an underfill is injected around the first joints between the wiring board and the plurality of dies and the second joints between the wiring layer and the plurality of dies.
(15) An electronic apparatus including:
   a plurality of dies; and
   a board apparatus including a wiring board and a wiring layer protruding from one surface of the wiring board and electrically connecting at least two of the plurality of dies to each other.
(16) An electronic device including:
   an electronic apparatus including:
   a plurality of dies; and
   a board apparatus including a wiring board and a wiring layer protruding from one surface of the wiring board and electrically connecting at least two of the plurality of dies to each other; and
   a circuit board on which the electronic apparatus is mounted.
(17) A method for manufacturing an electronic apparatus, the method including the steps of:
   forming a wiring layer on a wiring board in a convex shape; and
   connecting each of a plurality of dies and the wiring board to each other via a first joint and connecting each of the plurality of dies and the wiring layer to each other via a second joint.
(18) The method for manufacturing an electronic apparatus according to (17), in which
   the step of forming includes the sub-steps of:
   forming, on the wiring board, a layer in which a wiring is formed in a part, in an in-plane direction, of a photosensitive dielectric film; and
   removing another part, in the in-plane direction, of the photosensitive dielectric film from the layer through etching.
(19) The method for manufacturing an electronic apparatus according to (17), in which
   the step of forming repeats, a plurality of times, a cycle including the sub-steps of:
   stacking a dielectric film on the wiring board;
   etching the dielectric film to form a groove;
   forming a metal film on the dielectric film in which the groove is formed; and
   grinding the metal film to form a wiring.
(20) A method for manufacturing an electronic device, the method including the steps of:
   forming a wiring layer on a wiring board in a convex shape;
   connecting each of a plurality of dies and the wiring board to each other via a first joint and connecting each of the plurality of dies and the wiring layer to each other via a second joint to generate an electronic apparatus; and
   mounting the electronic apparatus on a circuit board.

### REFERENCE SIGNS LIST

1 Electronic device
10, 10-1, 10-2, 10-3, 10-4, 10-5, 10-6, 10-7, 10-8, 10-9, 10-10, 10-11, 10-12 Electronic apparatus
50 Board apparatus
100 Wiring board
100a Substrate
100b Internal wiring (wiring)
200 Die
300 Wiring layer
300a Insulating film
300b Internal wiring (wiring)
400 Underfill
J1 First joint
J2 Second joint

## Claims

1. A board apparatus comprising:
a wiring board; and
a wiring layer protruding from one surface of the wiring board and electrically connecting a plurality of dies to each other.

2. The board apparatus according to claim 1, wherein the one surface is a flat surface.

3. The board apparatus according to claim 1, wherein
the wiring board and each of the plurality of dies are connected to each other via a first joint, and
the wiring layer and each of the plurality of dies are connected to each other via a second joint.

4. The board apparatus according to claim 3, wherein the second joints are smaller than the first joints.

5. The board apparatus according to claim 3, wherein each of the first and second joints is a bump.

6. The board apparatus according to claim 3, wherein the first and second joints are metal joints.

7. The board apparatus according to claim 3, wherein a ratio of a pitch of the first joints to a pitch of the second joints is 2.0 or more and 5.0 or less.

8. The board apparatus according to claim 1, wherein the wiring layer has a plan view shape corresponding to planar arrangement of at least two of the dies.

9. The board apparatus according to claim 8, wherein the plan view shape is a quadrangle, an L-shape, a T-shape, a cross shape, a U-shape, a curved shape, or a combination of at least two of these.

10. The board apparatus according to claim 1, further comprising: a plurality of the wiring layers.

11. The board apparatus according to claim 1, wherein
the wiring layer includes:
an insulating film; and
a wiring disposed inside the insulating film, and
the insulating film includes a dielectric material.

12. The board apparatus according to claim 1, wherein
the wiring board includes:
a substrate; and
a wiring disposed inside the substrate, and
the substrate includes any of an organic substrate, an FOWLP, an FOPLP, a ceramic substrate, and a glass substrate.

13. The board apparatus according to claim 1, further comprising: a heat spreader disposed across surfaces of the plurality of dies on a side opposite a wiring board side.

14. The board apparatus according to claim 3, wherein an underfill is injected around the first joints between the wiring board and the plurality of dies and the second joints between the wiring layer and the plurality of dies.

15. An electronic apparatus comprising:
a plurality of dies; and
a board apparatus including a wiring board and a wiring layer protruding from one surface of the wiring board and electrically connecting at least two of the plurality of dies to each other.

16. An electronic device comprising:
an electronic apparatus including:
a plurality of dies; and
a board apparatus including a wiring board and a wiring layer protruding from one surface of the wiring board and electrically connecting at least two of the plurality of dies to each other; and
a circuit board on which the electronic apparatus is mounted.

17. A method for manufacturing an electronic apparatus, the method comprising the steps of:
forming a wiring layer on a wiring board in a convex shape; and
connecting each of a plurality of dies and the wiring board to each other via a first joint and connecting each of the plurality of dies and the wiring layer to each other via a second joint.

18. The method for manufacturing an electronic apparatus according to claim 17, wherein
the step of forming includes the sub-steps of:
forming, on the wiring board, a layer in which a wiring is formed in a part, in an in-plane direction, of a photosensitive dielectric film; and
removing another part, in the in-plane direction, of the photosensitive dielectric film from the layer through etching.

19. The method for manufacturing an electronic apparatus according to claim 17, wherein
the step of forming repeats, a plurality of times, a cycle including the sub-steps of:
stacking a dielectric film on the wiring board;
etching the dielectric film to form a groove;
forming a metal film on the dielectric film in which the groove is formed; and
grinding the metal film to form a wiring.

20. A method for manufacturing an electronic device, the method comprising the steps of:
forming a wiring layer on a wiring board in a convex shape;
connecting each of a plurality of dies and the wiring board to each other via a first joint and connecting each of the plurality of dies and the wiring layer to each other via a second joint to generate an electronic apparatus; and
mounting the electronic apparatus on a circuit board.
